# EUROPEAN PATENT SPECIFICATION

(11) **EP 2 930 215 B1**
(45) Date of publication and mention of the grant of the patent: **04.10.2017**
(21) Application number: 14164071.4
(22) Date of filing: 09.04.2014
(51) Int. Cl.: C09B 45/18, C09B 45/20, C09B 45/22, C09B 69/10, G03F 7/00, H01L 51/00, H01L 27/32

(54) **Imidazole metal complex azo dyes and their use as colorant for color resists**
Imidazol-Metallkomplex-Azofarbstoffe und deren Verwendung als Färbemittel für Farbschutzschichten
Colorants imidazolazoïques de complexe métallique et leur utilisation comme colorant pour des réserves de couleur

(43) Date of publication of application: 14.10.2015
(73) Proprietor: Cheil Industries Inc., Gumi-si, Gyeongsangbuk-do 730-030 (KR)
(72) Inventor: Plüg, Carsten, 64367 Mühltal (DE)
(74) Representative: dompatent von Kreisler Selting Werner - Partnerschaft von Patent- und Rechtsanwälten mbB

(56) References cited:
- EP-A1- 0 844 243
- WO-A1-94/00797
- WO-A1-2012/019704
- GB-A- 2 060 672
- JP-A- H1 058 828
- JP-A- S57 109 859
- JP-A- 2002 338 836
- US-A1- 2006 257 613

## Description

The present invention relates to imidazole-based azo metal complex dyes having improved contrast ratios as well as a method for the production of said dyes. Further, the invention relates to a curable dye composition comprising said imidazole-based azo metal complex dyes, a method for producing the same as well as the use of such compositions for color filters. Further, the present invention relates to a display comprising said imidazole-based azo metal complex dyes.

Liquid crystal displays (LCDs) are used in a wide range of applications, for example computer monitors, televisions, instrument panels, aircraft displays and signage. Especially the use of large screen LCDs has significantly increased. Despite their many advantages LCDs still suffer from several disadvantages, one of them being a rather poor color contrast, especially concerning the color red.

Up to date color filters are important parts in LCDs as they are used for providing colors among the many parts of a liquid crystal display. In order to achieve a high brilliance of color, color filters are employed that remove the long wave length part of the visible spectrum. The existing red color filter formulations employ predominantly C.I. Pigment Red 254 and C.I. Pigment Red 177 as red components for cutting off the long wave length part of the visible spectrum. The position of the absorption bands of these pigments and the resulting color filters can only be altered to a very small extent as the composition of the pigments is given, the color of pigmentary materials is determined by its crystal structure and crystal size, and the requirement of high transparency of color filters requires ultra-fine particles.

The replacement of CCFL (cold cathode fluorescent lambs) by white LED (light-emitting diodes) backlight and, more recently, by the introduction of white OLED (organic light-emitting diodes) backlight lead to the requirement to adjust the position of the color filters in use in order to achieve optimal brightness and transmission of the LCD display.

Most of the color filters used in liquid crystal displays (LCDs) employ photosensitive resin compositions that include a pigment as colorant. Although those pigment-based dyes offer excellent heat stability, the number of suitable pigments is rather limited. Additionally the pigments are only poorly compatible with the polymeric matrices used in color filters. The heterogeneity of those pigment dispersions results in rather poor contrast ratios since the pigment particles reflect, diffract, refract or interfere with light when light is transmitted. In addition, due to the limited number and substitution patterns of suitable pigments adjustment to, for example altered background light, or tuning of color properties of color filters is restricted.

Soluble red dyes have the advantage over red pigments that their color properties can be easily adjusted by altering the substitution on the chromophoric body. However, on adopting dyes from other application fields like disperse dyes, solvent dyes, acid dyes or others, up to now the required performance with respect to stability and optical performance could not be reached. In addition, these dyes have limited solubility and/or insufficient extinction to be applied in color filters.

Further, most of the commonly used dyes tend to migrate off the substrate upon exposure to heat. This disadvantage may be overcome by attaching polymerizable groups to the dyes so that they can be co-polymerized with acrylic co-monomers or resins to form polymers to which the dyes are covalently bound.

Accordingly, there is still a need for color filters to increase contrast ratio and brilliancy, in particular in combination with advanced lighting technology, while at the same time decreasing the possibility of leaching of the dyes during the manufacturing process of the color filters.

DE 25 14 581 A1 discloses imidazole azo dyes derived from 3-(N,N-dialkylamino)acetanilides for dying fibers made out of polyester, cellulose or mixtures thereof.

EP 0 844 243 B1 relates to sulfonamide compounds and methods for the production of said compounds, metal chelat compounds employing the sulfonamides and optical recording medium employing the metal chelat compounds.

US 2012/0187351 A1 discloses a colorant multimer that includes as partial structure of a colorant moiety, a dipyrromethane metal complex obtained from a dipyrromethane compound and a metal or metal compound.

JP 2000/309722 describes metal complexes of annelated imidazole azo dyes derived from inolines or quianazolines.

JP 2004/285241 describes oligomers of imidazole dyes from 3-(N,N-dialkylamino)acetanilides where two or more dyes are tethered by a suitable multivalent moiety.

JP 2002/338836 discloses a water-soluble azo metal chelate coloring matter for ink jet recording which is formed from an azo compound and which comprises 5 to 7 membered heterocyclic rings.

WO 2012/019704 discloses colored polymer particles comprising monomer units of at least one polymerizable dye comprising a chromophore and at least two polymerizable groups.

There is a substantial need for dyes for color filters that not only provide high contrast ratio, brilliancy and excellent thermal stability but also offer a broad substitution pattern to adjust the properties of the dye, such as absorption range or solubility. In regard to the fast developing field of LCDs, it would furthermore be desirable to be able to quickly and easily adjust the color filters to any arising technical changes, such as background light.

The dyes are required to combine good solubility in processing solvents with a high stability during the manufacturing process towards thermal stress and disintegration.

It is therefore an object of the present invention to provide dyes allowing to flexibly adjust the optical properties of red color filter compositions to the individual backlight characteristics of LED and OLED light sources by employing suitable dyes combining high light and providing process stability, compatibility to existing manufacturing processes and, brilliant hue, and high contrast ratio, while at the same time showing only limited tendency to leaching during the manufacturing process and a high durability.

It has surprisingly been found that specific imidazole azo metal complexes carrying polymerizable groups as defined in the present invention demonstrate high thermal stability and little loss during the manufacturing process of respective color filters, at the same time exhibiting a high color contrast.

The embodiment of the present invention is a display as defined in independent claim 1. Preferred embodiments are reflected in the dependent claims. A dye comprising of a metal complex comprising a metal ion M and a deprotonated form of compound of formula (I): 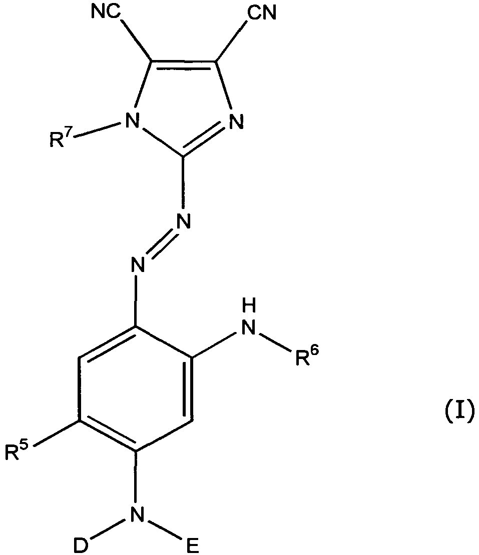 wherein
D is 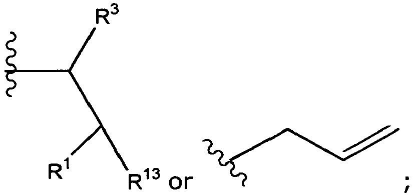
E is 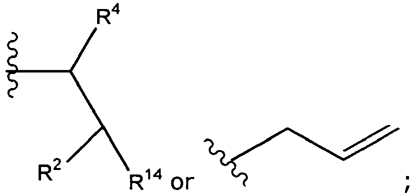
R¹ and R² are independently from each other selected from the group consisting of H, -OH, -CH₂OH -OC₁-C₈-alkyl, -C₁-C₆-alkyl, phenyl, -C(O)OC₁-C₈-alkyl, -O-benzyl, -O-allyl, -CN, -OC(O)-C₁-C₆-alkyl, -OC(O)CF₃, -OR⁸ and -R^{x}-OR⁸; preferably H and C₁-C₃-alkyl;
R³ and R⁴ are, independently from each other, selected from the group consisting of H, methyl, -CH₂OH, -C₁₋₆-alkyl, phenyl, -C(O)OC₁-C₈-alkyl, -OR⁸ and -R^{x}-OR⁸, preferably H and C₁-C₃-alkyl;
R⁵ is selected from the group consisting of -H, -C₁-C₈-alkyl, -OC₁-C₈-alkyl, -C(O)OC₁-C₈ alkyl, -R^{x}-OR⁸, -OC_{y}H_{2y}-R⁸ and -Cl, preferably H and - OMe;
R⁶ is selected from the group consisting of -C(O)CF₃, -S(O)₂C₁-C₁₂-alkyl, -S(O)₂CF₃, -S(O)₂N(C₁-C₈-alkyl)₂, -S(O)₂NR¹⁰R¹¹ and -S(O)₂-phenylen-C(R⁹)=CH₂, preferably -C(O)CF₃, -S(O)₂-phenylen-C(R⁹)=CH₂, -S(O)₂CF₃, -S(O)₂Me, -S(O)₂NMe₂;
R⁷ is selected from the group consisting of H, methyl, ethyl, branched or unbranched -C₃-C₆-alkyl, -C₃-C₆-alkenyl, -C₃-C₆-alkynyl -C₃-C₆-cycloalkyl, benzyl or substituted benzyl, -C_{y}H_{2y}-R⁸, -OC_{y}H_{2y}-R⁸, -R^{x}-OR⁸, -C₂H₄-CN,-C₂H₄-C(O)OC,-C₈-alkyl, -CH₂-CH(OH)-phenyl, -CH(phenyl)-CH₂(OH), -CH₂-CH(OR⁸)-phenyl and -CH(phenyl)-CH₂(OR⁸), preferably H and -C₄-alkenyl, especially vinyl;
wherein R⁸ is -C(O)-C(R⁹)=CH₂ or -S(O)₂-phenylen-C(R⁹)=CH₂.
wherein R⁹ is H or methyl;
wherein R¹⁰ and R¹¹ are independently either -C₁-C₆-alkyl or -R^{x}-OR⁸;
wherein y is an integer ranging from 1 to 4;
wherein R¹³ and R¹⁴ are independently selected from the group consisting of H, phenyl and -R^{x}-OR⁸;
wherein R^{x} is a -C₂-C₈-alkanediyl which may be substituted; and
wherein at least one of the substituents selected from R¹, R², R³, R⁴, R⁵, R⁶ and R⁷ comprises the moiety -C(O)-C(R⁹)=CH₂ or -S(O)₂-phenylen-C(R⁹)=CH₂ is used for the display of the invention.

In a preferred embodiment the substituent -OC₁₋₈-alkyl is selected from the group consisting of -OCH₃, -OCH₂CH₃, -OCH₂CH₂CH₃, -OC₄H₉, -OC₅H₁₁,-OC₆H₁₃, -OC₇H₁₅ and -OC₈H₁₇.

The substituent -COOC₁₋₈-alkyl is preferably selected from the group consisting of -COOCH₃, -COOCH₂CH₃, -COOCH₂CH₂CH₃, -COOC₄H₉, -COOC₅H₁₁,-COOC₆H₁₃, -COOC₇H₁₅ and -COOC₈H₁₇.

The substituent -C₁₋₈-alkyl is preferably selected from the group consisting of -CH₃, -CH₂CH₃, -CH₂CH₂CH₃, -CH(CH₃)₂, -C₄H₉, -C₅H₁₁, and -C₈H₁₇.

It has surprisingly been found that a complex of a metal ion and an azo compound which comprises at least one polymerizable group shows excellent adhesion and little leaching during the manufacturing process of a respective color filter, while at the same time exhibiting excellent thermal and chemical stability. Additionally, such complexes show a high compatibility with polymeric matrices used in the production of color filters thus leading to an improved homogeneity of the resist composition which in turn leads to high color resolution and color uniformity.

Therefore, in a preferred embodiment of the dye at least one of the substituents R⁶ and R⁷ comprise the moiety -C(O)-C(R⁹)=CH₂ or -S(O)₂-phenylen-C(R⁹)=CH₂.

Although it is known to the person skilled in the art that imidazole dyes carrying polymerizable groups can be employed in color filters the compounds suffer from poor light and heat stability. Surprisingly, those dyes showed a vastly improved thermal and chemical stability when employed in the form of a metal complex. Best results can be achieved when a divalent metal ion is used in the complex.

Therefore, an embodiment of the present invention is preferred wherein M is a divalent ion.

In a further preferred embodiment M is selected from the group consisting of copper(II), nickel(II), zinc(II), iron(II), manganese(II), tin(II) and cobalt(II).

Preferably the metal ion of the complex is chosen in a way as to improve the thermal and chemical stability of the dye. In addition it may be used to adjust the absorption range of the dye as the absorption spectra highly depends on the metal ion used. Complexes having the same ligands but different metal ions may absorb light of different wavelengths.

It has proven beneficial, if the dye can form a co-polymer with different acrylic or methacrylic co-monomers thus ensuring that the dye is covalently bound to the polymeric resin forming the different layers of a color filter. In that way, any undesired leaching of the dye during the manufacturing process of the color filter can be minimized while at the time achieving high thermal and chemical stability of the dye, resulting in improved color brilliance and resolution.

In order to achieve a lasting incorporation of the dye into the polymeric matrix forming part of the color filter it has been found that the co-polymerization of the dye and the respective polymer matrix is more effective in cases where the polymerizable group is attached to the dye via a linker, thus avoiding any sterical hindrance or strain of the molecule by ensuring free movement of the dye. The linker further provides the opportunity of introducing additional functional groups into the dye.

Accordingly, in a preferred embodiment, substituent R^{x} is a -C₂-C₈-alkandiyl substituted with substituents selected from the group consisting of - OH, -OC(O)CF₃, -OC(O)C₁-C₈-alkyl, -OC(O)phenyl, -OC(O)benzyl and -OC(O)C₅-C₆-cycloalkyl.

It could be shown that the properties of the dye, especially in regard to color brilliance, resolution, thermal and chemical stability as well as processability, could be adjusted and even tuned depending on the desired performance by careful selection of the substitution pattern of the dye. Especially the substituents R⁶ and R⁷ could be used to adjust the properties of the dye and improve its performance.

Therefore, an embodiment of the dye according to the invention is preferred wherein
R⁷ is selected from the group of -C_{y}H_{2y}-R⁸, R^{x}-OR⁸, -CH₂-CH(OR⁸)-phenyl and -CH(phenyl)CH₂(OR⁸);
R⁶ is -S(O)₂-N(Me)₂;
R⁸ is -C(O)-C(R⁹)=CH₂;
R⁹ is H or methyl;
y in an integer ranging from 1 to 4; and
R^{x} is a -C₂-C₈-alkanediyl which may be substituted.

Further preferred is an embodiment of the dye wherein R⁷ is H or methyl and R⁶ is selected from the groups consisting of -C(O)CF₃, -S(O)₂N(C₁-C₈-alkyl)₂ and - S(O)₂NR¹⁰R¹¹; wherein R¹⁰ and R¹¹ are independently from each other -C₁-C₆-alkyl or R^{x}-OR⁸, with the proviso that at least one of R¹⁰ and R¹¹ is R^{x}-OR⁸; wherein R^{x} is a -C₂-C₈-alkanediyl which may be substituted; wherein R⁸ is -C(O)-C(R⁹)=CH₂ and wherein R⁹ is H or methyl.

In a preferred embodiment R⁷ is a vinyl moiety.

In an especially preferred embodiment the dye according to the present invention is represented by formula (II): 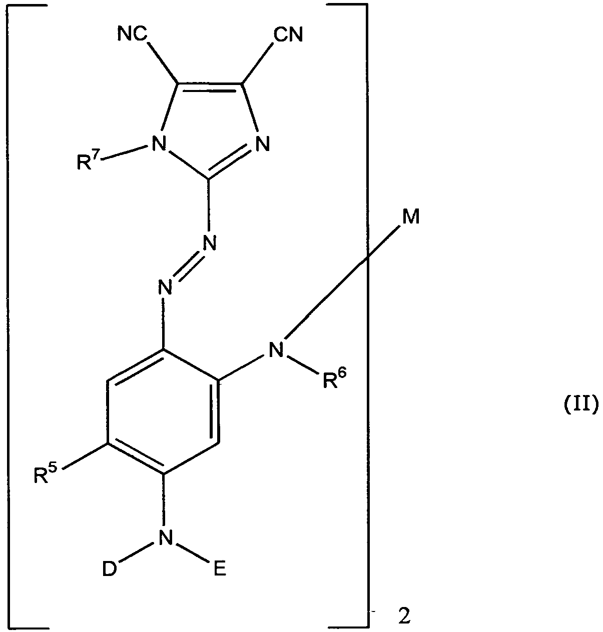 wherein
D is 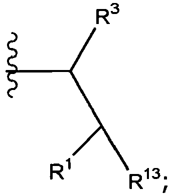
E is 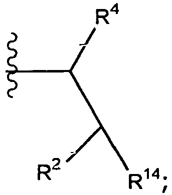 R¹ R², R³ and R⁴ are independently from each other H or methyl;
R⁵ is -H or -OCH₃;
R⁶ is either -C(O)CF₃ or -S(O)₂N(C₁-C₈-alkyl)₂;
R⁷ is 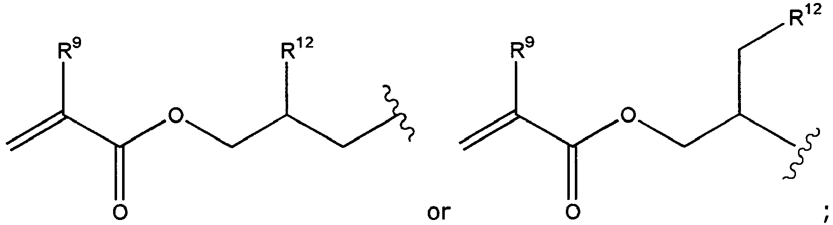
R⁹ is H or methyl;
R¹² is selected from the group consisting of -OH, - OC(O)phenyl, -OC(O)C₁-C₈-alkyl and -OC(O)CF₃, preferably -C(O)CF₃ and -OH;
R¹³ and R¹⁴ are both H; and
M is Ni or Zn.

In an alternatively preferred embodiment the dye according to the invention is represented by formula (III): 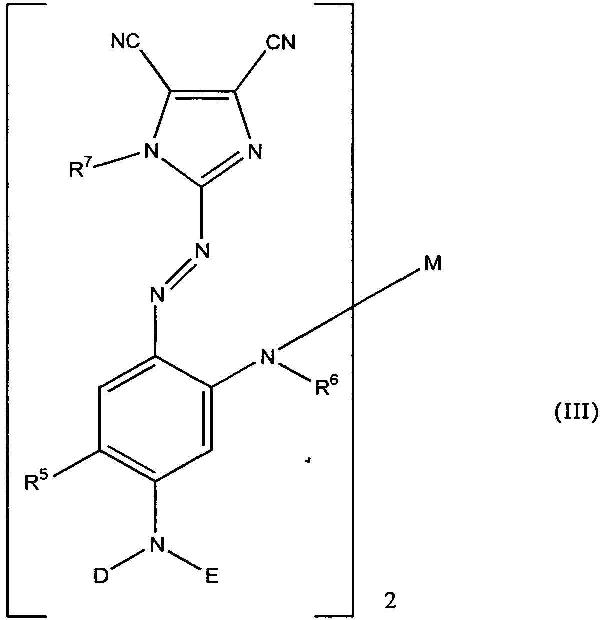 wherein
D is 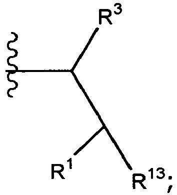
E is 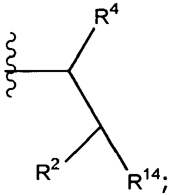
R¹ is -OH or -OR⁸;
R² is -OH or -OR⁸, with the proviso that if R¹ is -OH then R² is -OR⁸ and if R¹ is -OR⁸ then R² is -OH;
R³ and R⁴ are both H;
R⁵ is either -H or -OCH₃;
R⁶ is either -C(O)CF₃ or =S(O)₂N(C₁-C₈-alkyl)₂;
R⁷ is H;
R¹³ and R¹⁴ are independently from each other selected from the group consisting of H, phenyl and -CH₂-OR⁸;
R⁸ is -C(O)-C(R⁹)=CH₂ with R⁹ being either H or methyl; and
M is Ni or Zn.

Especially preferred is an embodiment of the dye wherein either D or E or both are

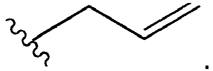

In a further preferred embodiment the dye is represented by formula (I) wherein
D is 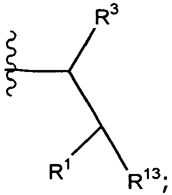
E is 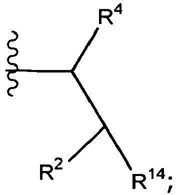
R¹, R², R³, R⁴, R¹³ and R¹⁴ are H;
R⁵ is either H or -OCH₃;
R⁶ is selected from the group consisting of -C(O)CF₃, -S(O)₂-phenylen-C(R⁹)=CH₂, -S(O)₂CH₃ and -S(O)₂N(CH₃)₂;
R⁷ is selected from the group consisting of H, 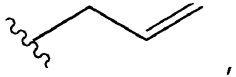 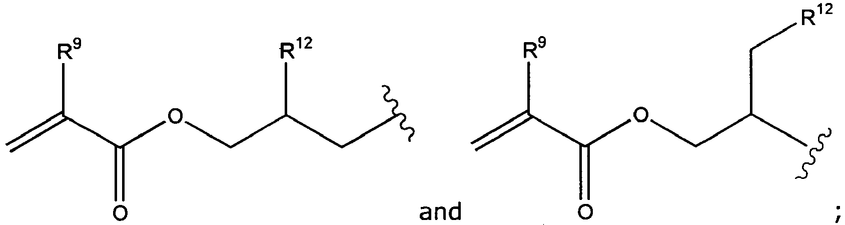
R⁹ is H or -CH₃; and
R¹² is -OH or -C(O)CF₃.

Further preferred is an embodiment wherein the -S(O)₂- moiety and the - C(R⁹)=CH₂-moitey of substituent -S(O)₂-phenylen-C(R⁹)=CH₂ are in para-position to each other.

The substitution pattern of the dye, respectively the substitution pattern of the ligand of the dye, may be used to adjust the properties of the dye. For example the introduction of long alkane chains as substituents to one or more of the aromatic moieties may improve the solubility of the complex in organic solvents.

A color filter usually consists of more than one layer of color resists, usually one layer for each of the colors red, blue and green. Due to subsequent application of the different color resists during the production the process involves several washing steps wherein any uncured resin is removed by washing. Therefore, it is desirable that the dye only possesses a limited solubility in the organic solvents that are used for washing so that the dye will not be flushed out of the cured resin.

In a preferred embodiment the dye may have a solubility of at least 1 wt.-%, preferably ranging from 2 to 20 wt.-% in an organic solvent which may be used in the curable dye composition, for example in a range from 3 to 12 wt.-% at 20 °C.

Preferably, the solubility of the dye of the present invention at 20 °C is at least 1 wt.-%, preferably 2 to 20 wt.-%, more preferably 3 to 12 wt.-% in at least one of the solvents selected from propylene glycol monomethylether acetate (PGMEA), ethyl 3-ethoxypropionate and cyclohexanone.

The solubility of the dyes of this invention may be measured as described below.

The dye (about 25 g) is dissolved in 100 g of the respective organic solvent and the solution is agitated for about 5 minutes to obtain a saturated solution at room temperature. 5 ml of the solution at the time when dye precipitation starts to generate is collected, and its weight measured. Then, the solution is dried at about 160 °C for about 2 hours, and the weight of the dye (unit: g) is measured, thereby measuring the solubility of the dye.

Preferably the dye has a maximum absorption wavelength within a wavelength region ranging from 450 to 600 nm, preferably from 500 to 560 nm, and a transmittance ranging from 85 to 100%, preferably from 95 to 100% within a wavelength region ranging from 580 to 800 nm in spectral analysis. When the dye has a maximum absorption wavelength and/or a transmittance within these ranges, it provides high luminance.

Color resists are exposed to elevated temperatures during the production process or later on under operating conditions. Therefore, the dye preferably has high heat resistance. Preferably, the dye according to the invention is thermally decomposed at 200 °C or higher, for example, at a temperature ranging from 250 to 400 °C, measured with a thermogravimetric analyzer (TGA).

Due to the high demands for displays having high color resolution and brilliance there is a constant need for improved color filters with the above mentioned properties.

Therefore, the dye is used in color filters.

The dye having the above characteristics can be used in the production of various products including without limitation a color filter such as for a LCD, LED, and the like. Furthermore, the dye provides high luminance and can provide a high contrast ratio in a desired color coordinate.

A method for preparing the dye, involving the following steps:
i) Providing a compound of formula (I) 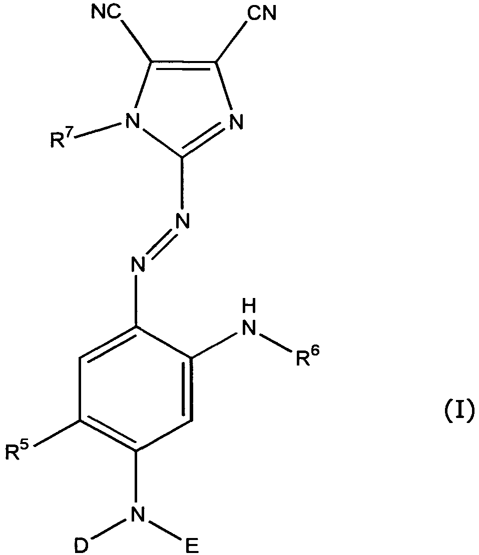 wherein
   D is 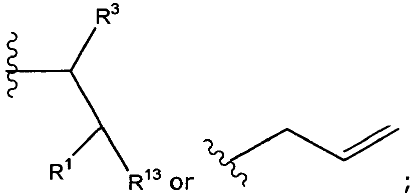
   E is 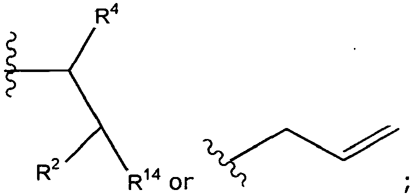
   R¹ and R² are independently from each other selected from the group consisting of H, -OH, -CH₂OH, -OC₁-C₈-alkyl, -C₁-C₆-alkyl, phenyl, -C(O)OC₁-C₈-alkyl, -O-benzyl, -O-allyl, -CN, -OC(O)-C₁-C₆-alkyl, -OC(O)CF₃, -OR⁸ and -R^{x}-OR⁸;
   R³ and R⁴ are, independently from each other, selected from the group consisting of H, methyl, -CH₂OH, -C₁-₆-alkyl, phenyl, -C(O)OC₁-C₈-alkyl, -OR⁸ and -R^{x}-OR⁸.
   R⁵ is selected from the group consisting of -H, -C₁-C₈-alkyl, -OC₁-C₈-alkyl, -C(O)OC₁-C₈ alkyl, -R^{x}-OR⁸, -OCyH_{2y}-R⁸ and -Cl;
   R⁶ is selected from the group consisting of -C(O)CF₃, -S(O)₂C₁-C₁₂-alkyl, -S(O)₂CF₃, -S(O)₂N(C₁-C₈-alkyl)₂, -S(O)₂NR¹⁰R¹¹ and -S(O)₂-phenylen-C(R⁹)=CH₂.
   R⁷ is selected from the group consisting of H, methyl, ethyl, branched or unbranched -C₃-C₆-alkyl, -C₃-C₆-alkenyl, -C₃-C₆-alkynyl -C₃-C₆-cycloalkyl, benzyl or substituted benzyl, -C_{y}H_{2y}-R⁸, -OC_{y}H₂y-R⁸, -R^{x}-OR⁸, -C₂H₄-CN,-C₂H₄-C(O)OC₁-C₈-alkyl, -CH₂-CH(OH)-phenyl, -CH(phenyl)-CH₂(OH), -CH₂-CH(OR⁸)-phenyl and -CH(phenyl)-CH₂(OR⁸);
   wherein R⁸ is -C(O)-C(R⁹)=CH₂ or -S(O)₂-phenylen-C(R⁹)=CH₂.
   wherein R⁹ is H or methyl;
   wherein R¹⁰ and R¹¹ are independently either -C₁-C₆-alkyl or -R^{x}-OR⁸;
   wherein y is an integer ranging from 1 to 4;
   wherein R¹³ and R¹⁴ are independently selected from the group consisting of H, phenyl and -R^{x}-OR⁸;
   wherein R^{x} is a -C₂-C₈-alkanediyl which may be substituted; and
   wherein at least one of the substituents selected from R¹, R², R³, R⁴, R⁵, R⁶ and R⁷ comprises the moiety -C(O)-C(R⁹)=CH₂ or -S(O)₂-phenylen-C(R⁹)=CH₂ and either
iia) reacting the compound of formula (I) with a reactant (A) comprising the moiety of -C(O)-C(R⁹)=CH₂ or -S(O)₂-phenylen-C(R⁹)=CH₂; and
iiia) forming a metal complex of the product of step iia) with a divalent metal ion;
   or
iib) forming a metal complex of the compound of formula (I) with a divalent metal ion; and
iiib) reacting the product of step iib) with a with a reactant (A) comprising the moiety of -C(O)-C(R⁹)=CH₂ or -S(O)₂-phenylen-C(R⁹)=CH₂, is disclosed.

The method for preparing the dye may be carried out in any scale desirable.

The method should be easy to carry out and allow for a safe handling of the components. The method usually does not require any special equipment.

In a preferred embodiment the preparation of the dye used according to the invention is carried out in the presence of a solvent, preferably an organic solvent.

Preferably, the solvent is chosen with regard to the solubility of the compound of formula (I) and the other components used for the preparation of the dye. In a preferred embodiment the solvent is chosen in such a way that it might dissolve the compound of formula (I) and the metal ion M and allows isolation of the dye by precipitation after formation or by addition of water, providing a simple method of isolation of the product.

Accordingly, an embodiment is preferred wherein the solvent is selected from the group consisting of methanol, ethanol, isopropanol, N,N-dimethylformamide (DMF), N-methylpyrrolidone (NMP), N,N-dimethylacetamide (DMAc) and dimethylsulfoxide (DMSO).

In order for the metal complex to be formed within a reasonable amount of time the compound of formula (I) or the product of step iiia) is deprotonated. Deprotonation as used herein refers to the abstraction of a proton from an organic molecule. Deprotonation is hence carried out by a base, preferably a metal hydroxide, metal alcoholate and/or metal carbonate, especially alkali metal hydroxide and/or carbonate.

Further preferred is an embodiment of the invention wherein the base is selected from the group consisting of sodium hydroxide and sodium methanolate.

Chemical reactions may be carried out at elevated temperatures in order to provide the energy required for the reaction to proceed and to shorten the time until the formation of the complex is complete. On the other hand, the reaction temperature should not be too high as to avoid any thermal decomposition of the reaction components and/or the product, unnecessary waste of resources and undesired side reactions.

Thus, an embodiment is preferred wherein the formation of a metal complex in step iiia) or iib) is carried out at temperatures above 40 °C, preferably from 50 °C to 150 °C, especially preferred from 60 °C to 100 °C.

In a preferred embodiment the dye is isolated from the reaction mixture by addition of water and subsequently dried. Any residuals may be removed by washing the dye with a suitable washing agent, for example water. Also preferred is an embodiment wherein reaction enhancing compounds, such as a catalyst, may be added when necessary.

In a preferred embodiment the reaction mixture may further contain additives. The additives may be used, for example, to adjust the pH of the reaction mixture or to prevent side reactions by neutralizing side products.

Preferably the dye according to the invention can be co-polymerized with co-monomers forming the polymeric matrix of the subsequent color filter.

Consequently, the reactant (A) should be in consideration of the compatibility with other monomers, suitable polymerization properties as well as thermal and chemical stability to be employed in the method according to the invention as well as the following manufacturing process of the color filter. In addition, it would be desirable for reactant (A) to process certain storage stability to allow easy storage and safe handling.

Therefore, in a preferred embodiment reactant (A) is selected from the group consisting of glycidyl(meth)acrylate, 4-(chlorosulfonyl) styrene and (meth)acrylolchloride. As used herein, the term "(meth)acryl" refers to both, acryl and methacryl when no specific definition is otherwise provided.

The dye according to the invention can either be co-polymerized with other suitable polymerizable compounds to be incorporated into the polymeric matrix of the color filter, or it can be polymerized as a homo-polymer which will then form one of the layers of the color filter. The method of choice depends on the color filter to be manufactured as well as on the desired properties of the respective color filter.

A further aspect is thus a polymer comprising at least one monomer unit derived from a dye according to the invention.

Different colors of, for example a display, are usually generated with the help of color resists that only transmit light of a certain wavelength. The color resists are usually prepared by mixing a dye with a polymeric resin. This mixture is then applied to a matrix and cured by selective exposure to light. In order to be able to mix any desirable color, different layers of different color resists are used, each layer containing a differently colored dye, usually the colors red, blue and green.

The process for applying the mixture may include, for example spin coating, roll coating, Meyer bar coating, doctor blade coating, gravure coating, reverse gravure coating, kiss reverse coating; die coating, or comma coating.

A further aspect is a curable dye composition comprising:
a) a dye according to the invention or a polymer according to the invention;
b) a radically polymerizable compound (B) differing from the dye according to the invention or the polymer according to the invention; and
c) a photoinitiator
d) solvent.

Usually the dye used in the color resist is the most expensive component since its synthesis is in most cases rather tedious. Therefore, it is desirable to keep the amount of dye needed to achieve the desired effects, such as for example high color brilliance, in the color resist as low as possible in order to save production costs and to preserve resources.

Thus, an embodiment is preferred wherein, in the case the curable dye composition comprises the dye used according to the invention, the dye used according to the invention is present in an amount ranging from 0.1 to 30 wt.-%, preferably from 3.0 to 20 wt.-%, especially preferred 3.0 to 10 wt.-%, based on the total weight of the curable dye composition.

In an alternatively preferred embodiment, in the case the curable dye composition comprises the polymer according to the invention the polymer is present in an amount ranging from 1.0 to 50 wt.-%, preferably from 5.0 to 40 wt.-%, especially preferred 10-30 wt.-%, based on the total weight of the curable dye composition.

The curable dye composition comprises a radically polymerizable compound (B) differing from the dye according to the invention and the polymer according to the invention.

Suitable radically polymerizable compounds (B) may include, but are not limited to, ethylene glycol di(meth)acrylate, diethylene glycol di(meth)acrylate, triethylene glycol di(meth)acrylate, propylene glycol di(meth)acrylate, neopentyl glycol di(meth)acrylate, 1,4-butanediol di(meth)acrylate, 1,6-hexanediol di(meth)acrylate, bisphenol A di(meth)acrylate, pentaerythritol di(meth)acrylate, pentaerythritol tri(meth)acrylate, pentaerythritol tetra(meth)acrylte, pentaerythritol hexa(meth)acrylate, dipentaerythritol di(meth)acrylate, dipentaerythritol tri(meth)acrylate, dipentaerythritol penta(meth)acrylate, dipentaerythritol hexa(meth)acrylate, bisphenol A epoxy (meth)acrylate, ethylene glycol monomethylether (meth)acrylate, trimethylol propane tri(meth)acrylate, tris(meth)acryloyloxyethyl phosphate, novolac epoxy (meth)acrylate or combinations thereof.

Polymerizable compound (B) as used herein refers to monomeric and/or oligomeric compounds as well as mixtures thereof. Further, polymerizable compounds can be acrylic based resins.

In a preferred embodiment the radically polymerizable compound (B) is present in an amount of 1 to 40 wt.-%, preferably 1.5 to 30 wt.-%, based on the total weight of the curable dye composition.

In a preferred embodiment the radically polymerizable compound (B) is an acrylic-based binder resin. The acrylic-based binder resin is preferably a copolymer of a first ethylenic unsaturated monomer and a second ethylenic unsaturated monomer that is copolymerizable with the first ethylenic unsaturated monomer, and a resin including at least one acrylic-based repeating unit.

The first ethylenic unsaturated monomer is preferably an ethylenic unsaturated monomer including at least one carboxyl group. Examples of the first ethylenic unsaturated monomer including at least one carboxyl group include without limitation acrylic acid, methacrylic acid, maleic acid, itaconic acid, fumaric acid, and the like, and combinations thereof.

The acrylic-based resin may comprise the first ethylenic unsaturated monomer in an amount ranging from 5 to 50 wt %, for example, from 10 to 40 wt %, based on the total weight of the acrylic-based binder resin. Further, according to some embodiments of the present invention, the amount of the first ethylenic unsaturated monomer can be in a range from any of the foregoing amounts to any other of the foregoing amounts.

The second ethylenic unsaturated monomer may comprise, without limitation, aromatic vinyl compounds such as styrene, α-methylstyrene, vinyltoluene, vinylbenzylmethylether, and the like; unsaturated carboxylic acid ester compounds such as methyl(meth)acrylate, ethyl(meth)acrylate, butyl(meth)acrylate, 2-hydroxyethyl(meth)acrylate, 2-hydroxy butyl(meth)acrylate, benzyl(meth)acrylate, cyclohexyl(meth)acrylate, phenyl(meth)acrylate, and the like; unsaturated carboxylic acid amino alkyl ester compounds such as 2-aminoethyl(meth)acrylate, 2-dimethylaminoethyl(meth)acrylate, and the like; carboxylic acid vinyl ester compounds such as vinyl acetate, vinyl benzoate, and the like; unsaturated carboxylic acid glycidyl ester compounds such as glycidyl(meth)acrylate and the like; vinyl cyanide compounds such as (meth)acrylonitrile and the like; unsaturated amide compounds such as (meth)acrylamide and the like; and the like. The second ethylenic unsaturated monomer may be used singularly or as a mixture of two or more ethylenic unsaturated monomers.

Examples of the acrylic-based binder resin may include without limitation a methacrylic acid/benzylmethacrylate copolymer, a methacrylic acid/benzylmethacrylate/styrene copolymer, a methacrylic acid/benzylmethacrylate/2-hydroxyethylmethacrylate copolymer, a methacrylic acid/benzylmethacrylate/styrene/2-hydroxyethylmethacrylate copolymer, and the like. The acrylic-based binder resin may be used singularly or as a mixture of two or more acrylic-based binder resins.

The acrylic-based binder resin may have a weight average molecular weight ranging from 3000 to 150,000, preferably from 5000 to 50,000, for example, from 20,000 to 30,000. When the acrylic-based binder resin has a weight average molecular weight within these ranges, the composition has excellent close contacting (adhesive) properties with a substrate, good physical and chemical properties, and appropriate viscosity.

The acrylic-based binder resin may have an acid value ranging from 15 to 60 mg KOH/g, for example from 20 to 50 mg KOH/g. When the acrylic-based binder resin has an acid value within these ranges, it brings about excellent pixel resolution.

In a preferred embodiment, the curable dye composition may comprise the acrylic-based binder resin in an amount ranging from 1 to 30 wt %, for example, from 5 to 20 wt %, based on the total weight of the curable dye composition. In some embodiments, the curable dye composition may include the acrylic-based binder resin in an amount from at least 1 up to 30 wt.-% and with increasing preference in the order given of at least 2, at least 3, at least 4, at least 5, at least 6, at least 7, at least 8, at least 9, at least 10, at least 11, at least 12, at least 13, at least 14, at least 15, at least 16, at least 17, at least 18, at least 19, at least 20, at least 21, at least 22, at least 23, at least 24, at least 25, at least 26, at least 27, at least 28 and at least 29 wt.-%, based on the total weight of the curable dye composition. Further acrylic-based binder resin may be present in an amount of up to 30 wt.-% to at least 1 wt.-% and with increasing preference in the order given of up to 29, up to 28, up to 27, up to 26, up to 25, up to 24, up to 23, up to 22, up to 21, up to 20, up to 19, up to 18, up to 17, up to 16, up to 15, up to 14, up to 13, up to 12, up to 11, up to 10, up to 9, up to 8, up to 7, up to 6, up to 5, up to 4, up to 3 and up to 2 wt.-%, based on the total weight of the curable dye composition. Further, according to some embodiments of the present invention, the amount of the acrylic-based binder resin can be in a range from any of the foregoing amounts to any other of the foregoing amounts.

When the acrylic-based binder resin is included in an amount within these ranges, it was found that the composition has excellent developing properties and improved cross-linking, and thus has excellent surface flatness when fabricated into a color filter.

In an alternatively preferred embodiment the radically polymerizable compound (B) may include a multi-functional monomer having two or more hydroxyl groups. Examples of the radically polymerizable compound may include without limitation glycerol acrylate, dipentaerythritol hexaacrylate, ethylene glycol diacrylate, triethylene glycol diacrylate, 1,4-butanedioldiacrylate, 1,6-hexanediol diacrylate, neopentyl glycol diacrylate, pentaerythritol diacrylate, pentaerythritol triacrylate, pentaerythritol diacrylate, dipentaerythritol triacrylate, dipentaerythritol acrylate, pentaerythritol hexaacrylate, bisphenol A diacrylate, trimethylol propane triacrylate, novolacepoxy acrylate, ethylene glycol dimethacrylate, diethylene glycol dimethacrylate, triethylene glycol dimethacrylate, propylene glycol dimethacrylate, 1,4-butanediol dimethacrylate, 1,6-hexanediol dimethacrylate, and the like, and combinations thereof.

In a further preferred embodiment the radically polymerizable compound (B) may be present in an amount up to 30 wt.-%, such as ranging from 1 to 15 wt.-%, preferably from 5 to 10 wt.-%, based on the total weight of the curable dye composition. In some embodiments, the curable dye composition may comprise the radically polymerizable compound (B) in an amount from at least 1 to up to 15 wt.-% and with increasing preference in the order given of at least 2, at least 3, at least 4, at least 5, at least 6, at least 7, at least 8, at least 9, at least 10, at least 11, at least 12, at least 13 and at least 14 wt.-%. Further, the radically polymerizable compound (B) may be present in the curable dye composition in an amount of up to 15 to at least 1 wt.-% and with increasing preference in the order given of up to 14, up to 13, up to 12, up to 11, up to 10, up to 9, up to 8, up to 7, up to 6, up to 5, up to 4, up to 3 and up to 2 wt.-%, based on the total weight of the curable dye composition, respectively.

In an especially preferred embodiment the radically polymerizable compound (B) is a (meth)acrylate, preferably selected from the groups consisting of benzyl(meth)acrylate, butyl(meth)acrylate and 2-ethylhexyl(meth)acrylte.

It was found, that the composition exhibits excellent pattern characteristics and developing properties, when the radically polymerizable compound (B) was present in the above mentioned amounts.

The curable dye composition further comprises a photoinitiator.

The photoinitiator may be any photopolymerization initiator known in the art for preparing photosensive resin compositions for color filter. Exemplary photoinitiators may include without limitation acetophenone-based compounds, benzophenone-based compounds, thioxanthone-based compounds, benzoin-based compounds, triazine-based compounds, oxime-based compounds and the like and combinations thereof.

Exemplary acetophenone-based compounds may include without limitation 2,2'-diethoxyacetophenone, 2,2'-dibutoxyacetophenone, 2-hydroxy-methylpropioacetophenone, p-t-butyltrichloroacetophenone, p-t-butyldichloroacetophenone, 4-chloroacetophenone, 2,2'-dichloro-4-phenoxyacetophenone, 2-methyl-1-(4-methylthio)phenyl)-2-morpholinopropane-1-one, 2-benzyl-2-dimethylamino-1-(4-morpholinophenyl)-butane-1-one and the like as well as combinations thereof.

Exemplary benzophenone-based compounds may include without limitation benzophenone, benzoyl benzoic acid, benzoyl benzoic acid methyl, 4-phenyl benzophenone, hydroxyl benzophenone, acrylic benzophenone, 4,4'-bis(dimethyl amino)benzophenone, 4,4'-bis(diethylamino)benzophenone, 4,4'-dimethylaminobenzophenone, 4,4'-dichlorobenzophenone, 3,3'-dimethyl-2-methoxybenzophenone, and the like and combinations thereof.

Exemplary thioxanthone-based compounds may include without limitation thioxanthone, 2-methylthioxanthone, isopropyl thioxanthone, 2,4-diethyl thioxanthone, 2,4-diisopropyl thioxanthone, 2-chlorothioxanthone, and the like as well as combinations thereof.

Exemplary benzoin-based compounds may include without limitation benzoin, benzoin methyl ether, benzoin isobutyl ether, benzoin ethyl ether, benzoin isopropyl ether, benzyldimethylketal, and the like, as well as combinations thereof.

Exemplary triazine-based compounds max include without limitation 2,4,6-trichloro-s-triazine, 2-phenyl 4,6-bis(trichloromethyl)-s-triazine, 2-(3',4'-dimethoxystyryl)-4,6-bis(trichloromethyl)-s-triazine, 2-(4'-methoxynaphthyl)-4,6-bis(trichloromethyl)-s-triazine, 2-(p-methoxyphenyl)-4,6-bis(trichloromethyl)-s-triazine, 2-(*p*-tolyl)-4,6-bis(trichloromethyl)-s-triazine, 2-biphenyl 4,6-bis(trichloromethyl)-s-tiazine, bis(trichloromethyl)-6-styryl-s-triazine, 2-(naphtha-1-yl)-4,6-bis(trichloromethyl)triazine, 2-(4-methoxynaphtha-1-yl)-4,6-bis(trichloromethyl)triazine, 2-4-trichloromethyl(piperonyl)-6-triazine, 2-4-trichloromethyl (4'-methoxystyryl)-6-triazine, and the like, and combination thereof.

Exemplary oxime-based compounds may include without limitation 2-(*o-*benzoyloxime)-1-[4-(phenylthio)phenyl]-1,2-octanedione, 1-(*o*-acetyloxime)-1-[9-ethyl-6-(2-methylbenzoyl)-9H-carbazole-3-yl]ethanone, and the like and combinations thereof.

Exemplary photoinitiators may also include carbazole-based compounds, diketone-based compounds, sulfonium borate-based compounds, nonimidazole-based compounds, and the like, and combinations thereof, in addition to or as an alternative to the aforementioned photoinitiators.

In a preferred embodiment the photoinitiator is present in amount ranging from 0.1 to 10 wt.-%, based on the total weight of the curable dye composition. In an especially preferred embodiment the photoinitiator is present in an amount ranging from 0.5 to 5 wt.-%, based on the total weight of the curable dye composition.

When the photoinitiator is present in an amount within these ranges, the composition can be sufficiently photopolymerized when exposed to light during the pattern-forming process for preparing a color filter, and also exhibits excellent sensitivity and improved transmittance.

In a preferred embodiment the curable dye composition further comprises a solvent.

The solvent is not specifically limited. Examples of the solvent include without limitation alcohols such as methanol, ethanol, and the like; ethers such as dichloroethyl ether, n-butyl ether, diisoamyl ether, methylphenyl ether, tetrahydrofuran, and the like; glycol ethers such as ethylene, glycol monomethylether, ethylene glycol monoethylether, and the like; cellosolve acetates such as methyl cellosolve acetate, ethyl cellosolve acetate, diethyl cellosolve acetate, and the like; carbitols such as methylethyl carbitol, diethyl carbitol, diethylene glycol monomethylether, diethylene glycol monoethylether, diethylene glycol dimethylether, diethylene glycol methylethylether, diethylene glycol diethylether, and the like; propylene glycol alkylether acetates such as propylene glycol methylethyl acetate, propylene glycol methylether acetate, propylene glycol propylether acetate, and the like; aromatic hydrocarbons such as toluene, xylene, and the like; ketones such as methylethylketone, cyclohexanone, 4-hydroxy-4-methyl-2-pentanone, methyl-n-propylketone, methyl-n-butylketone, methyl-n-amylketone, 2-heptanone, and the like; saturated aliphatic monocarboxylic acid alkyl esters such as ethyl acetate, n-butyl acetate, isobutyl acetate, and the like; lactic acid alkyl esters such as methyl lactate, ethyl lactate, and the like; hydroxyacetic acid alkyl esters such as methyl hydroxyacetate, ethyl hydroxyacetate, butyl hydroxyacetate, and the like; acetic acid alkoxyalkyl esters such as methoxymethyl acetate, methoxyethyl acetate, methoxybutyl acetate, ethoxymethyl acetate, ethoxyethyl acetate, and the like; 3-hydroxypropionic acid alkyl esters such as methyl 3-hydroxypropionate, ethyl 3-hydroxypropionate, and the like; 3-alkoxypropionic acid alkyl esters such as methyl 3-methoxypropionate, ethyl 3-methoxypropionate, ethyl 3-ethoxypropionate, methyl 3-ethoxypropionate, and the like; 2-hydroxypropionic acid alkyl esters such as methyl 2-hydroxypropionate, ethyl 2-hydroxypropionate, propyl 2-hydroxypropionate, and the like; 2-alkoxypropionic acid alkyl esters such as methyl 2-methoxypropionate, ethyl 2-methoxypropionate, ethyl 2-ethoxypropionate, methyl 2-ethoxypropionate, and the like; 2-oxy-2-methylpropionic acid alkyl esters such as methyl 2-hydroxy-2-methylpropionate, ethyl 2-hydroxy-2-methylpropionate, and the like; 2-alkoxy-2-methylpropionic acid alkyl esters such as methyl 2-methoxy-2-methylpropionate, ethyl 2-ethoxy-2-methylpropionate, and the like; esters such as 2-hydroxyethyl propionate, 2-hydroxy-2-methylethyl propionate, hydroxyethyl acetate, methyl 2-hydroxy-3-methylbutanoate; ketonic acid esters such as ethyl pyruvate; and the like, and combinations thereof. Furthermore, the solvent may be N-methylformamide, N,N-dimethyl formamide, N-methylformanilide, N-methylacetamide, N,N-dimethyl acetamide, N-methylpyrrolidone, dimethylsulfoxide, benzylethylether, dihexylether, acetyl acetone, isophorone, caproic acid, caprylic acid, 1-octanol, 1-nonanol, benzyl alcohol, benzyl acetate, ethyl benzoate, diethyl oxalate, diethyl maleate, [gamma]-butyrolactone, ethylene carbonate, propylene carbonate, phenyl cellosolve acetate, and the like. These solvents may be used singularly or in a combination.

In exemplary embodiments, taking into account factors such as miscibility, reactivity, and the like, examples of the solvent may include without limitation glycol ethers such as ethylene glycol monoethyl ether and the like; ethylene glycol alkylether acetates such as ethyl cellosolve acetate and the like; esters such as 2-hydroxyethyl propionate and the like; diethylene glycols such as diethylene glycol monomethyl ether and the like; propylene glycol alkylether acetates such as propylene glycol monomethylether acetate, propylene glycol propylether acetate, and the like; and combinations thereof.

The solvent may be present in a balance amount, for example, in an amount ranging from 20 to 90 wt.-%, based on the total weight of the curable dye composition. In some embodiments, the curable dye composition may comprise the solvent in an amount of at least 20 and up to 90 wt.-% and with increasing preference in the order given of at least 21, at least 22, at least 23, at least 24, at least 25, at least 26, at least 27, at least 28, at least 29, at least 30, at least 31, at least 32, at least 33, at least 34, at least 35, at least 36, at least 37, at least 38, at least 39, at least 40, at least 41, at least 42, at least 43, at least 44, at least 45, at least 46, at least 47, at least 48, at least 49, at least 50, at least 51, at least 52, at least 53, at least 54, at least 55, at least 56, at least 57, at least 58, at least 59, at least 60, at least 61, at least 62, at least 63, at least 64, at least 65, at least 66, at least 67, at least 68, at least 69, at least 70, at least 71, at least 72, at least 73, at least 74, at least 75, at least 76, at least 77, at least 78, at least 79, at least 80, at least 81, at least 82, at least 83, at least 84, at least 85, at least 86, at least 87, at least 88 and at least 89 wt.-%, based on the total weight of the curable dye composition, respectively. Further, the curable dye composition may comprise the solvent in an amount of up to 90 to at least 20 wt.-% and with increasing preference in the order given of up to 89, up to 88, up to 87, up to 86, up to 85, up to 84, up to 83, up to 82, up to 81, up to 80, up to 79, up to 78, up to 77, up to 76, up to 75, up to 74, up to 73, up to 72, up to 71, up to 70, up to 69, up to 68, up to 67, up to 66, up to 65, up to 64, up to 63, up to 62, up to 61, up to 60, up to 59, up to 58, up to 57, up to 56, up to 55, up to 54, up to 53, up to 52, up to 51, up to 50, up to 49, up to 48, up to 47, up to 46, up to 45, up to 44, up to 43, up to 42, up to 41, up to 40, up to 39, up to 38, up to 37, up to 36, up to 35, up to 34, up to 33, up to 32, up to 31, up to 30, up to 29, up to 28, up to 27, up to 26, up to 25, up to 24, up to 23, up to 22 and up to 21 wt.-%, based on the total weight of the curable dye composition, respectively. Further, according to some embodiments of the present invention, the amount of the solvent can be in a range from any of the foregoing amounts to any other of the foregoing amounts.

It was found that, when the solvent was present in an amount within these ranges, the curable dye composition had excellent coating properties and maintained excellent flatness in a layer having a thickness of 3 µm or more.

The curable dye composition according to the invention may further comprise a surfactant to uniformly disperse the dye into the solvent and to improve leveling performance.

The surfactant may be fluorine-based.

The fluorine-based surfactant may have a weight average molecular weight ranging from 4000 to 10,000, for example, from 6000 to 10,000. In addition, the fluorine-based surfactant may have surface tension ranging from 18 to 23 mN/m (measured in a 0.1% polyethylene glycol methylether acrylate (PEGMEA) solution). When the fluorine-based surfactant has a weight average molecular weight and surface tension within these ranges, the composition shows improved leveling performance and an excellent stain characteristic during high speed coating. In addition, the composition generates less vapor and less defects in a layer, so that the composition is suitable for high speed coating methods, for example slit coating methods.

Examples of the fluorine-based surfactant may include without limitation F-482, F-484, F-478, and the like, and combinations thereof, which are commercially available from DIC Co., Ltd.

Other exemplary surfactants may include silicon-based surfactants, in addition to or as an alternative to the fluorine-based surfactant.

Examples of the silicon-based surfactant may include without limitation TSF400, TSF401, TSF410, TSF4440, and the like, and combinations thereof, which are commercially available from Toshiba Silicon Co., Ltd.

The curable dye composition may include the surfactant in an amount ranging from 0.01 to 5 wt.-%, for example, from 0.1 to 2 wt.-%, based on the total weight of the curable dye composition. When the surfactant is included in an amount within these ranges, the composition shows fewer impurities generated after development.

The curable dye composition may further include other additives such as but not limited to malonic acid, 3-amino-1,2-propanediol, and/or a vinyl- or (meth)acryloxy-containing silane-based coupling agent, in order to prevent stains or spots during the coating, to adjust leveling, or to prevent pattern residue due to non-development. These additives may be added in conventional amounts, which can be readily selected by the skilled artisan based on desired properties.

In addition, the curable dye composition may additionally include an epoxy compound to improve the close contacting (adhesive) properties and other characteristics if needed.

Exemplary epoxy compounds may include without limitation epoxy novolac acryl carboxylate resins, ortho cresol novolac epoxy resins, phenol novolac epoxy resins, tetra methyl biphenyl epoxy resins, bisphenol A-type epoxy resins, alicyclic epoxy resins, and the like, and combinations thereof.

For cases where the epoxy compound is present in the curable dye composition, a peroxide initiator or a radical polymerization initiator such as an azobis-based initiator can additionally be present in the curable dye composition.

The curable dye composition may include the epoxy compound in an amount of 0.01 to 5 wt.-%, based on the total weight of the curable dye composition. When the epoxy compound is included in an amount ranging from 0.01 to 5 wt.-%, it can improve storage, close contacting (adhesion), and other properties.

In a preferred embodiment an antioxidant and/or a UV light absorbent additive may be added to increase the durability of the curable dye composition.

In a preferred embodiment the curable dye composition may comprise the following components:
i) 0.1 to 30 wt.-% of a dye according to the invention or a polymer according to the invention;
ii) 1.0 to 40 wt.-% of a radically polymerizable compound (B);
iii) 0.1 to 10 wt.-% of a photoinitiator;
iv) optionally 0.01 to 5 wt.-% of a surfactant;
v) optionally 0.01 to 5 wt.-% of an epoxy compound;
vi) optionally 0.1 to 5 wt.-% of further additives other than those mentioned under iv) and v); and
vii) optionally a solvent, preferably in an amount to balance the curable dye composition to 100 wt.-%.

The curable dye composition according to the invention has excellent heat resistance and durability, high absorption in a wavelength region ranging from 400 to up to 620 nm, high luminance, and high contrast ratio, and thus can be used to provide a color filter that has improved pattern characteristics, development processability, chemical resistance, color reproducibility, and the like.

After the curable dye composition is applied to a surface, for example glass that serves as base of the color filter, the curable dye composition is preferably cured by the selective exposure to light, for example by employment of a laser. The cured dye composition is preferably in the form of a film and serves as one colored layer, preferably as the red layer, of the color filter.

Therefore, a further embodiment of the present invention is a cured dye composition obtainable by curing a curable dye composition according to the invention. The curing is preferably a photocuring.

As the person skilled in the art may know, the time of the curing process as well as the energy and wavelength of the light source, for example the laser, vary depending on the nature of the dye, the nature of the radically polymerizable compound as well as on the photoinitiator used. Preferably energy and wavelength are chosen in a way that the curable dye composition can be thoroughly cured without causing any damage to the dye present. Preferably the curing is conducted in a way that the cured dye composition shows a proper adhesion to the surface.

There is no particular limitation regarding the method used to prepare the curable dye composition. The curable dye composition can be prepared by mixing the dye according to the invention or the polymer according to the invention, the radically polymerizable compound (B), the photoinitiator, and optionally any of the above mentioned compounds and/or additives.

The color filter may be fabricated using any suitable conventional method. For example, the color filter may be prepared using spin-coating, roller-coating, slit-coating, and the like to form a layer of the composition on a suitable substrate, the layer having a thickness ranging from 1.5 to 3.0 µm. After coating the composition to form a layer, the layer is exposed to radiation, such as UV radiation, electron beam, or X-ray to form a pattern required for a color filter. The UV radiation may have a wavelength region ranging from 190 to 450 nm, for example, from 200 to 400 nm. Next, the coated layer is treated with an alkali developing solution, and the unradiated (non-exposed) region thereof may be dissolved, forming a pattern for an image color filter. This process can be repeated as necessary to form the desired number of red, green, and blue colors, to fabricate a color filter having a desired pattern. In addition, the image pattern acquired by the development step can be cured through heat treatment, actinic ray radiation, or the like, which can improve crack resistance, solvent resistance, and the like.

The application of color filters is not limited to LC-displays. They can also be found in cameras and other optical devices. Thus, a further aspect of the present invention is the use of a dye used according to the invention or a polymer used according to the invention or a curable dye composition used according to the invention or a cured dye composition used according to the invention for color filters.

In LC-displays the light source, namely the background light, is usually present in the form of a foil that comprises OLEDs which provide white light (W-OLED). Since the spectral range of white light emitted by an OLED slightly differs from that of a conventional light source, the dyes used in color filters have to be adjusted to achieve high contrast and color brilliance. Therefore, it is desirable to have dyes the absorption range of which can be easily modified, for example by manipulation of the substitution pattern of the ligand.

Thus, a embodiment of the invention is a display containing
- a W-OLED light source; and
- a color filter comprising a dye according to the invention.

The invention is further described by but not limited to the following examples.

### Example1:

### Example 1a:

A compound of the following formula (IV) was prepared according to the following procedure:
18 ml of concentrated hydrochloric acid were treated with 8.24 g (60 mmol) of 2-amino-4,5-dicyano-imidazole (available from Aldrich) and cooled to 0 °C. 13.2 ml (66 mmol) of 5N sodium nitrite solution was added drop-wise over a period of 30 minutes. After completion, the excess of nitrite was destroyed by adding amidosulfonic acid.

A mixture of 16.5 g (60 mmol) of 3-(N,N)-diethylamino-4-methoxy trifluoroacetanilide dissolved in 60 ml of glacial acetic acid and adjusted to pH 4.5 by addition of 60 ml 30% NaOH solution. To this mixture the diazonium salt solution was added drop-wise at about 0 to 5 °C while the pH of the mixture was maintained. After stirring for 30 minutes the mixture was filtered and the residue was washed with warm water until it was free of chlorides and dried under reduced pressure at 80 °C to provide 17.6g (67%) of the compound of formula (IV). 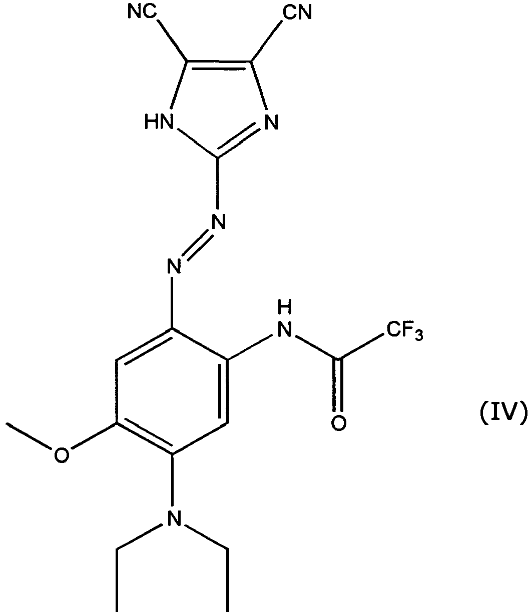 ¹H NMR (CDCl₃, TMS standard, 400 MHz, ppm): 10,99 (s, 1H), 8,31 (s, 1H), 7,30 (s,1H), 3.51 (q, 4H, 7.0 Hz), 2,50 (s, 3H), 1.18 (t, 6H, 7.0 Hz).
UV-VIS: ε at λₘₐₓ = 535 nm: 76 (L*cm⁻¹*g⁻¹, propylene glycole monomethylether acetate)
Solubility in propylene glycole monomethylether acetate: 0.1% (wt/wt).

### Example 1b:

2.00 g (4.6 mmol) of the compound of example 1a, formula (IV) was dispersed in 10 ml of dioxane and treated with 0.71 g (5.0 mmol) of glycidyl methacrylate and 0.05 g of potassium carbonate. The mixture was refluxed for 9 h, poured into 100 ml of water, treated with 10 g of sodium chloride, filtered and dried over night at 60° C to obtain 2.48 g (94%) of the desired dye in mixture of isomers of structures of formulae (Va) and (Vb). 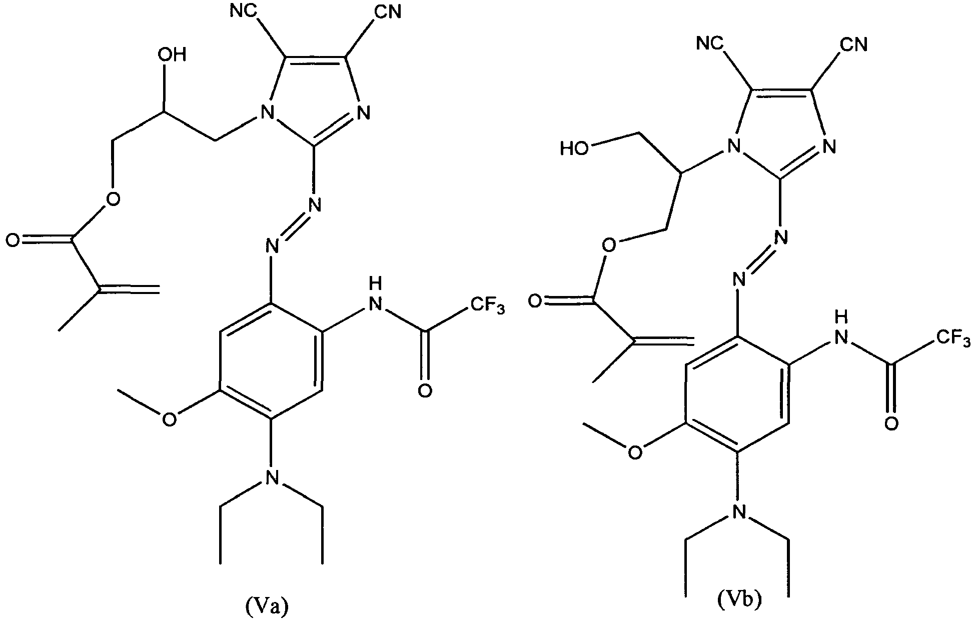 UV-VIS: ε at λₘₐₓ = 545 nm: 69 (L*cm⁻¹*g⁻¹, propylene glycole monomethylether acetate)
¹H NMR (CDCl₃, TMS standard, 400 MHz, ppm): 10.22 (br, 1H) 8.05, 8.00 (2s, 1H), 7.39, 7.34 (2s, 1H), 6.19, 6.15 (2s, 1H), 5.67, 5.63 (2s, 1H), 4.84-3.97 (m, 5,5 H), 3.92, 3.89 (2s, 3H), 3.86-3.45 (m, 3.5 H), 1.99, 1.96 (2s, 3H), 1.38-1.18 (m, 6H). The two sets of signals are in agreement with the formation of two isomers in a ratio of appr. 1:1.
Solubility in propylene glycole monomethylether acetate: 1.0% (wt/wt)

### Example 1c:

1.00 g (1.7 mmol) of the compound of example 1b, formula (V) was dissolved in 40 ml of ethanol and 423 mg (1.7 mmol) of nickel(II)acetate tetrahydrate and 50 mg of potassium carbonate were added and the mixture was stirred at 50 °C for a period of 8 hour. After cooling down to 20 °C, the reaction mixture was filtered, poured into 50 ml of water and precipitated by addition of 10ml of saturated sodium chloride solution. The precipitate was filtered off, washed with water chloride-free, dried under reduced pressure to yield 900 mg (86%) of the desired dye of the structure of formula (VI) and isomers. 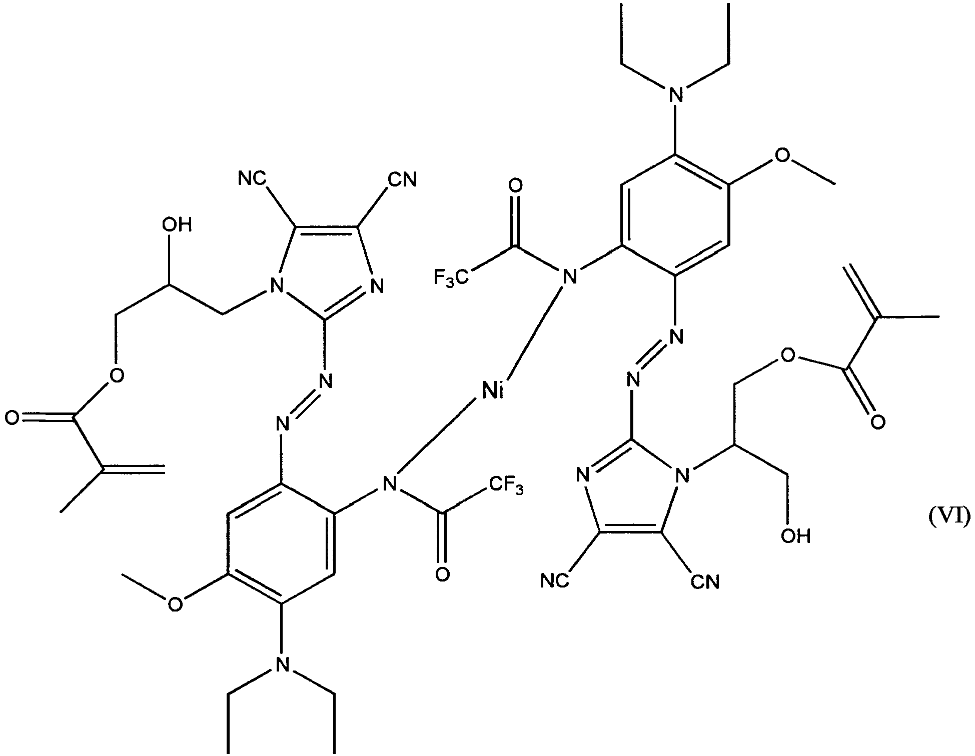 UV-VIS: ε at λₘₐₓ = 552 nm: 15 (L*cm⁻¹*g⁻¹, propylene glycole monomethylether acetate)
Solubility in propylene glycole monomethylether acetate: <0.1% (wt/wt)

### Example 2:

### Examble 2a:

9.85 g (60 mmol) 3-*N,N*-diethylamino-aniline, 9.1 g sodium bicarbonate in 50 ml of tolune was treated with 12.8 g (63 mmol) of 4-chlorosulfonyl styrene within 2 min, The resulting mixture was refluxed for 4 h, kept at 90° C for 14 h, after cooling down, washed three times with 100 ml water, dried over sodium sulfate and evaporated to dryness to provide 14.3 g (47 %) of a dark solid material of the following structure (VII): 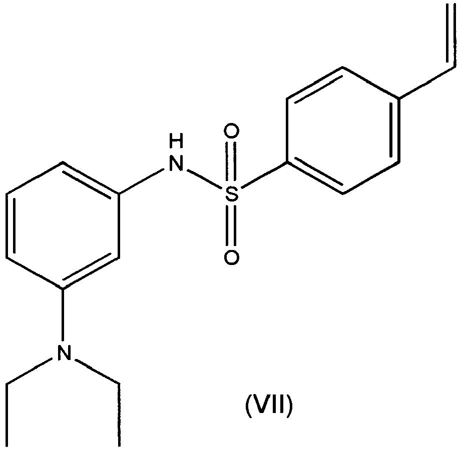 ¹H NMR (CDCl₃, TMS standard, 400 MHz, ppm): 7.78 (d, 2H, 7.5 Hz), 7.43 (d, 2H, 7.5 Hz), 7,02 (dd, 1H, 7.9 Hz), 6.82 (br, 1H), 6.71 (d,1H, 11.1, 17,6 Hz), 6.43-6.37 (m, 2H), 6.30-6.25 (m, 1H), 5.82 (d, 1H, 17.6 Hz), 5,38 (d, 1H, 11.1 Hz), 3.26 (q, 4H, 7.0 Hz), 1.08 (t, 6H, 7.0 Hz).

### Example 2b:

A diazo solution was prepared in the following way: 80 ml of water was treated with 12 ml of hydrochloric acid (32 wt.%) and 5.3 g (40 mmol) of 2-amino-4,5-dicyano-imidazole (Aldrich), cooled to 0 °C, and treated drop-wise with 8.4 ml (44 mmol) 5N sodium nitrite solution within 30 min. After completion the excess of nitrite was destroyed by adding amidosulfonic acid.

A mixture of 13,7 g (40 mmol) 3-*N,N*-diethylamino-(4-styroenesulfonyl) anilide, formula (VII),example 2a, and 100 mg of 4-methoxyphenol in 40 ml of glacial acetic acid was treated with 50 ml 32% sodium hydroxide solution to adjust the pH to 4.5. This mixture was treated drop-wise with the diazo solution prepared above at 0-5° C. After stirring for 15 min, the precipitate was filtered off, washed with 1000 ml of water and dried at 60 °C *in vaccuo* to provide 16.3 g (86 %) of a dye of the following structure (VIII): 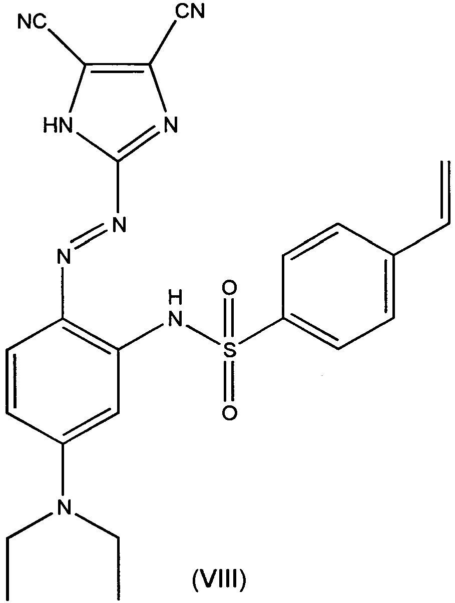 UV-VIS: ε at λₘₐₓ = 510 nm: 85 (L*cm⁻¹*g⁻¹, propylene glycole monomethylether acetate)
Solubility in propylene glycole monomethylether: 0.1% (wt/wt)

### Example 2c:

1.50 g (3 mmol) of the compound of example 2b, formula (VIII) was dissolved in 50 ml of methanol and 373 mg (1.5 mmol) of nickel(II)acetate tetrahydrate were added and the mixture was refluxed for 1h. After cooling down to 20 °C, 50 mg of 4-methoxyphenol were added, the mixture was filtered over Celite and precipitated in 100ml of water. After evaporation of the methanol at reduced pressure, 8.0 g of sodium chloride were added. The precipitate was filtered off, washed chloride free and dried under reduced pressure to yield 1,33 g (71%) of the desired dye of the structure of formula (IX): 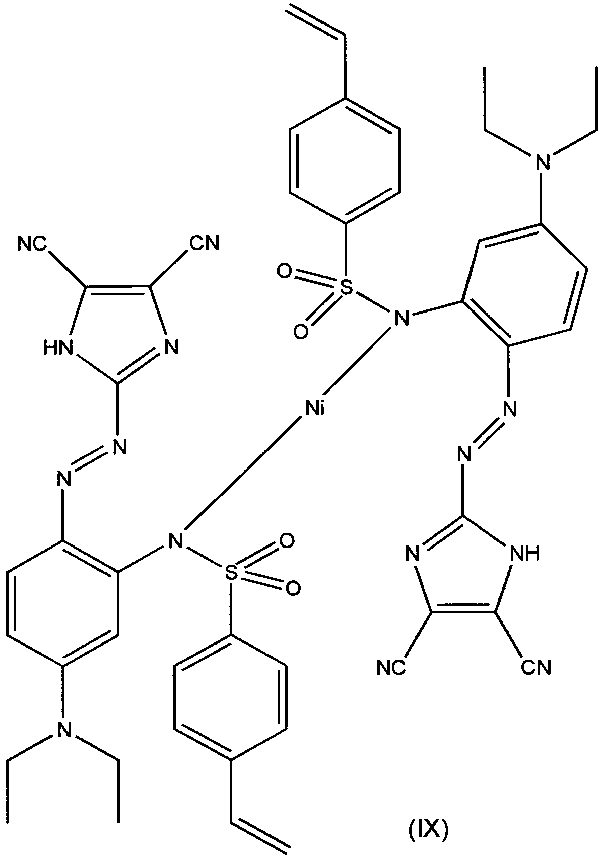 UV-VIS: ε at λₘₐₓ = 533 nm: 62 (L*cm⁻¹*g⁻¹, propylene glycole monomethylether acetate)
Solubility in propylene glycole monomethylether acetate: 0.1% (wt/wt)

### Examples 3

### Example 3a: Azo coupling

On subjecting 3-N,N-diethylamino-methylsulfonylanilide to azo coupling described in example 1a, there was obtained 91% of the azo compound of formula (X) 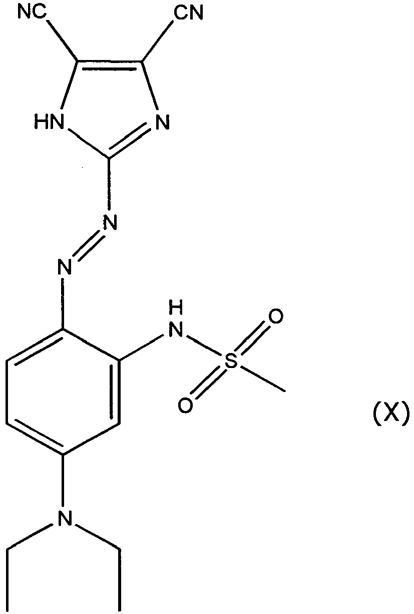 UV-VIS: ε at λₘₐₓ = 535 nm: 152 (L*cm⁻¹*g⁻¹, propylene glycole monomethylether acetate)
Solubility in propylene glycole monomethylether acetate: 0.1% (wt/wt)

### Example 3b: Treatment with glycidylmethacrylate

15.0 g (38.8 mmol) of the azo dye, described in example 3a, was dissolved in 50 ml of N-methylpyrrolidone, treated with 8.83 g (46.6 mmol) of glycidylmethacrylate (CAS 106-9-2) and 1.0 mg of potassium carbonate. The mixture was heated to 100-110° C under nitrogen atmosphere for 4h, after cooling, drowned into 1200 ml of water and the dye was filtered off. The residue was collected, washed with water and dried at 60° C i.vac. to provide 16.9 g (82%) of the polymerizable azo compound of formulae (XIa) and (XIb). 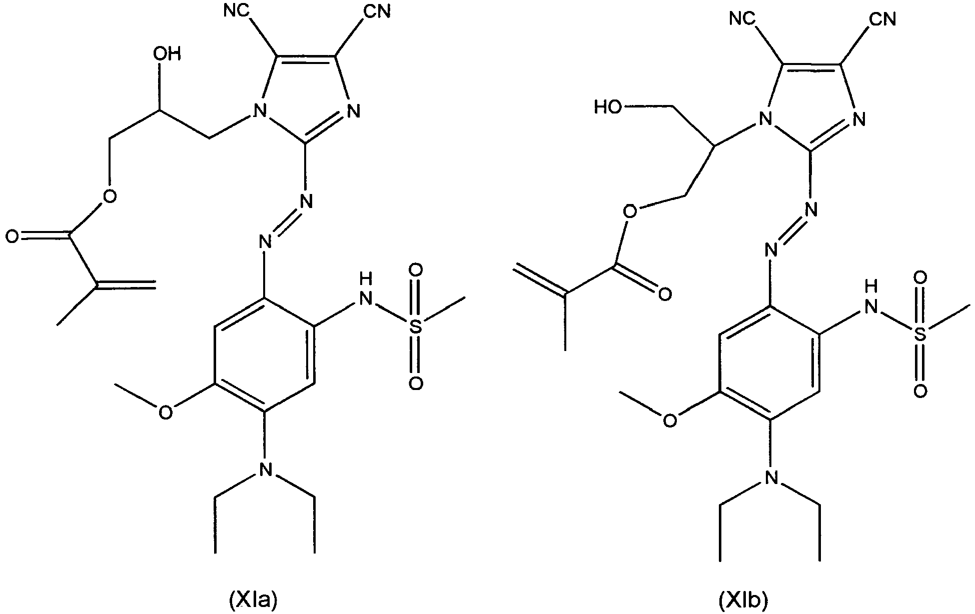 UV-VIS: ε at λₘₐₓ = 502 nm: 69 (L*cm⁻¹*g⁻¹, propylene glycole monomethylether acetate)
Solubility in propylene glycole monomethylether acetate: 0.1% (wt/wt)

### Example 3c:

2.00 g (3.6 mmol) of the compound of example 3b, formulae (XIa) and (XIb) was dissolved in 50 ml of methanol and 245 mg (1.8 mmol) of anhydrous zinc chloride were added and the mixture was refluxed for 3h. After cooling down to 20 °C, the mixture was precipitated in 100ml of water. The precipitate was filtered off, washed chloride free and dried under reduced pressure to yield 1,57 g (75%) of the desired mixture of isomers, with the main dye of the structure of formula (XII): 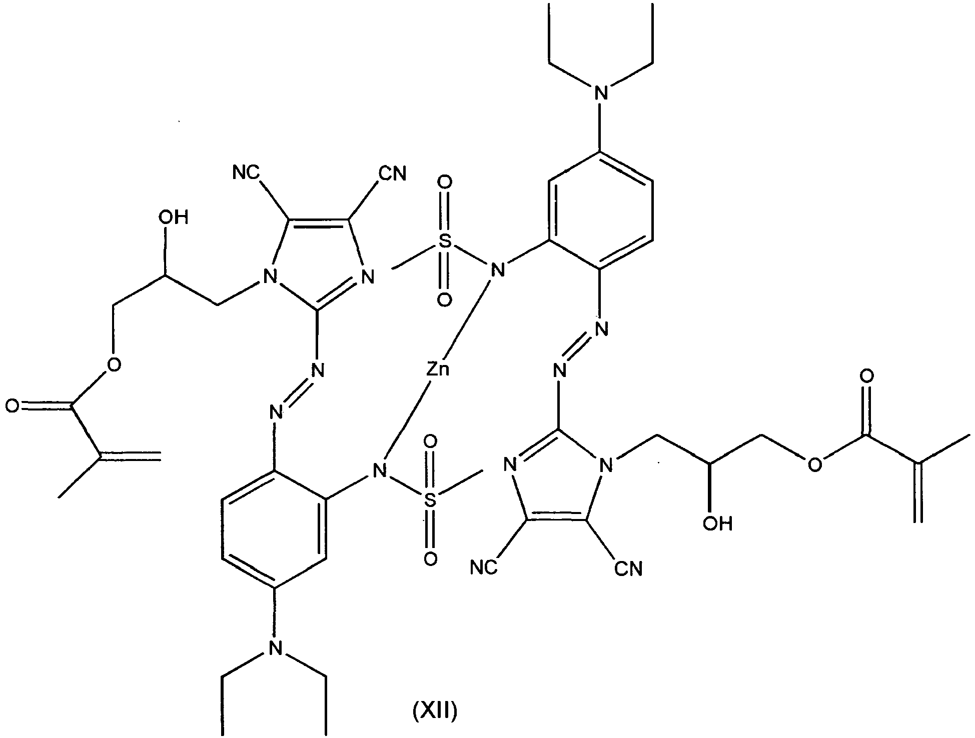 UV-VIS: ε at λₘₐₓ = 537 nm: 72 (L*cm⁻¹*g⁻¹, propylene glycole monomethylether acetate)
Solubility in propylene glycole monomethylether acetate: 0.5% (wt/wt)

### Example 4

### Example 4a: Azo coupling

On subjecting 3-N,N-diethylamino-4-methoxy-methylsulfonyl acetanilide to azo coupling described in example 1a, there was obtained 97% of the azo compound of formula (XIII) 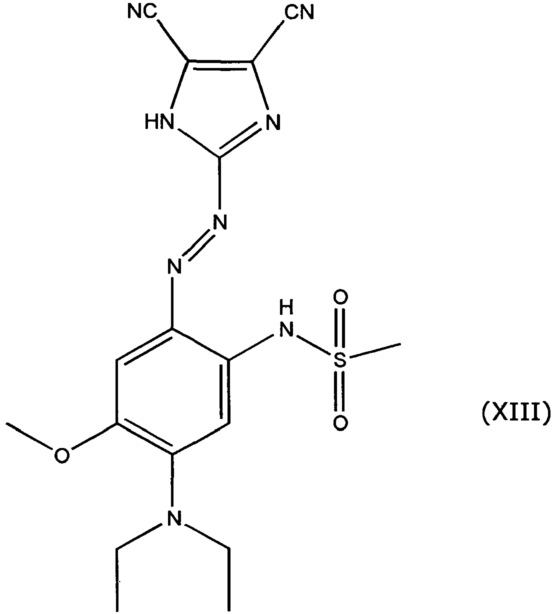 UV-VIS: ε at λₘₐₓ = 548 nm: 85 (L*cm⁻¹*g⁻¹ propylene glycole monomethylether acetate)
Solubility in propylene glycole monomethylether acetate: 0.1% (wt/wt)

### Example 4b: Treatment with glycidylmethacrylate

2.0 g (5.4 mmol) of the azo dye, described in example 4a, was dissolved in 10ml of dioxane, treated with 0.77g (5.4 mmol) of glycidylmethacrylate (CAS 106-9-2) and 20 mg of potassium carbonate. The mixture was refluxed under nitrogen atmosphere for 9h, after cooling drowned into 100 ml of water, treated with 10 of sodium chloride. The residue was collected, washed with water and dried at 60° C i.Vac to provide 2.0 g (80%) of the polymerizable azo compound of formulae (XIVa) and (XIVb) 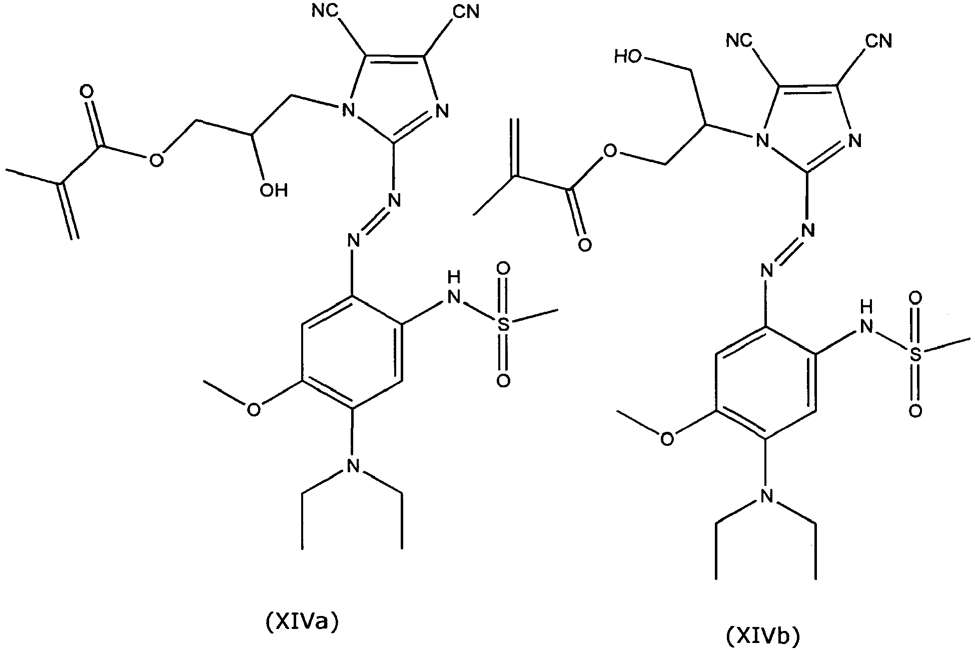 UV-VIS: ε at λₘₐₓ = 535 nm: 85 (L*cm⁻¹*g⁻¹ propylene glycole monomethylether acetate)
Solubility in propylene glycole monomethylether acetate: 0.1% (wt/wt)
¹H NMR (CDCl₃, TMS standard, 400 MHz, ppm): 7,21 (s, 1H), 6,85 (s,1H), 6.23 (s, 1H), 5.63 (s, 1H), 4.58-4.40 (m, 6H), 4.40-4,30 (m, 1H), 3.88 (s, 3H), 3.87 (d, 2H), 3.64-3.44 (br+m, 5H), 3.07 (s, 3H), 1.28 (t, 6H, 8.0 Hz). In addition to the main set of signals about 10% of a byproduct, presumably the isomer formed by ring opening at the 2-position can be detected.

### Example 4c: Treatment with trifluoroacetanhydride

2.0 g (3.7 mmol) of the azo dye, described in example 4b, was dissolved in 20ml of dichloromethane, treated with 0.39 g (3.9 mmol) of triethylamine and subsequently dropwise with 0.82 g (3.9 mmol) of trifluoro acetanhydride. After stirring for 90 min the mixture was washed with three times 20 ml of water, dried over sodium sulfate, filtered and the solvent was evaporated to dryness to obtain 2.32 g (95%) of the polymerizable azo compound of formulae (XVa) and (XVb) 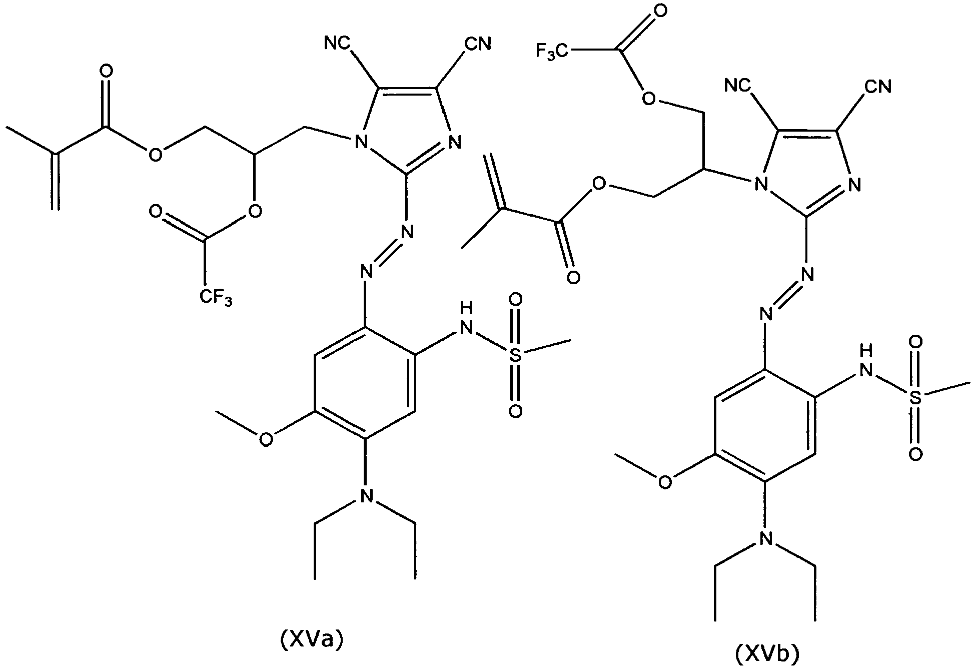 UV-VIS: ε at λₘₐₓ = 544 nm: 51 (L*cm⁻¹*g⁻¹, propylene glycole monomethylether acetate)
Solubility in propylene glycole monomethylether acetate: 0.5% (wt/wt)

### Example 5

### Example 5a: Azo coupling

On subjecting 3-N,N-diethylamino-4-methoxy-(N',N'-diethylamido)sulfonylanilide to azo coupling described in example 1a, there was obtained 99% of the azo compound of formula (XVI) 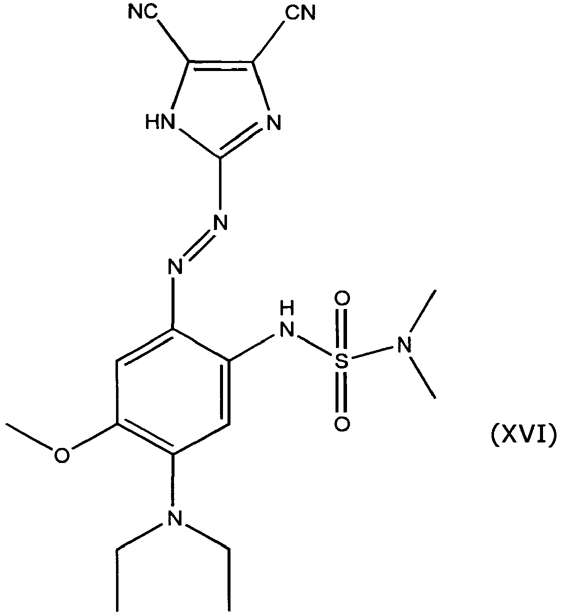 UV-VIS: ε at λₘₐₓ = 551 nm: 85 (L*cm⁻¹*g⁻¹, propylene glycole monomethylether acetate)
Solubility in propylene glycole monomethylether acetate: 0.5 % (wt/wt)

### Example 5b - Reaction with glycidylmethacrylate

On subjecting the azo dye described in example 5a to reaction with glycidylmethacrylate according to the conditions described in example 1b, there was obtained 86% of the azo compound in a mixture of isomers of formulae (XVIIa) and (XVIIb) 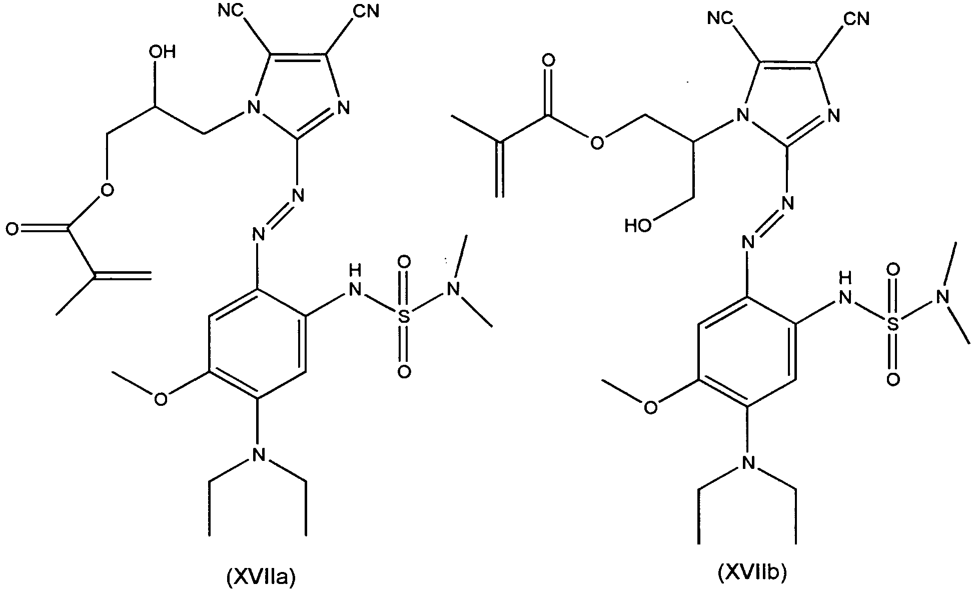 UV-VIS: ε at λₘₐₓ = 538 nm: 55 (L*cm⁻¹*g⁻¹, propylene glycole monomethylether acetate)
Solubility in propylene glycole monomethylether acetate: 2.5 % (wt/wt)

### Example 6

### Example 6a: Azo coupling

On subjecting 3-N,N-diethylamino-(N',N'-dimethylamido)sulfonylanilide to azo coupling described in example 1a, there was obtained 73% of the azo compound of formula (XVIII) 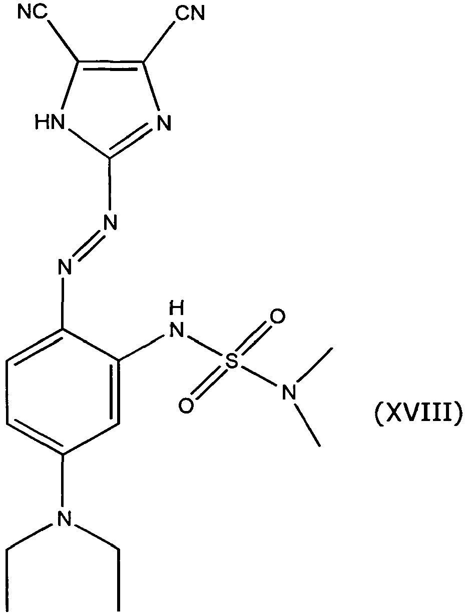 UV-VIS: ε at λₘₐₓ = 508 nm: 88 (L*cm⁻¹*g⁻¹, propylene glycole monomethylether acetate)
Solubility in propylene glycole monomethylether acetate: 2.5 % (wt/wt)

### Example 6b - Reaction with glycidylmethacrylate

On subjecting the azo dye described in example 6a to reaction with glycidylmethacrylate according to the conditions described in example 1b, there was obtained 55% of the azo compound in a mixture of isomers of formulae (XIXa) and (XIXb) 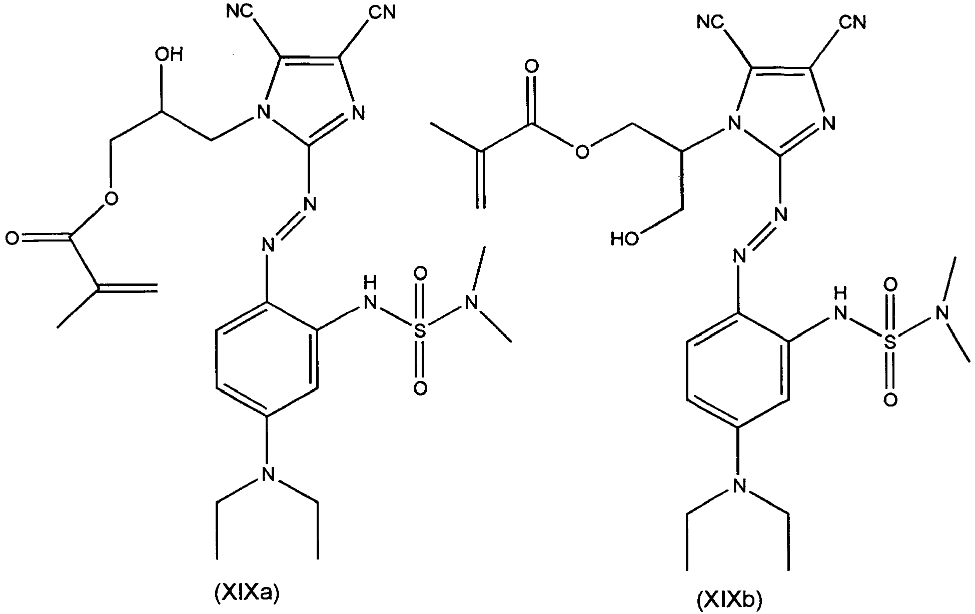 UV-VIS: ε at λₘₐₓ = 501 nm: 63 (L*cm⁻¹*g⁻¹, propylene glycole monomethylether acetate)
Solubility in propylene glycole monomethylether acetate: 5% (wt/wt)

### Examples 7-10: Non-metal containing azo dyes

The following examples were prepared by the methods described above.

**Table 1:**

| Example | Formula | UV-VIS (PGMEA, 0.001%): λₘₐₓ (nm) /ε (m²/g) |
|---|---|---|
| 7 | 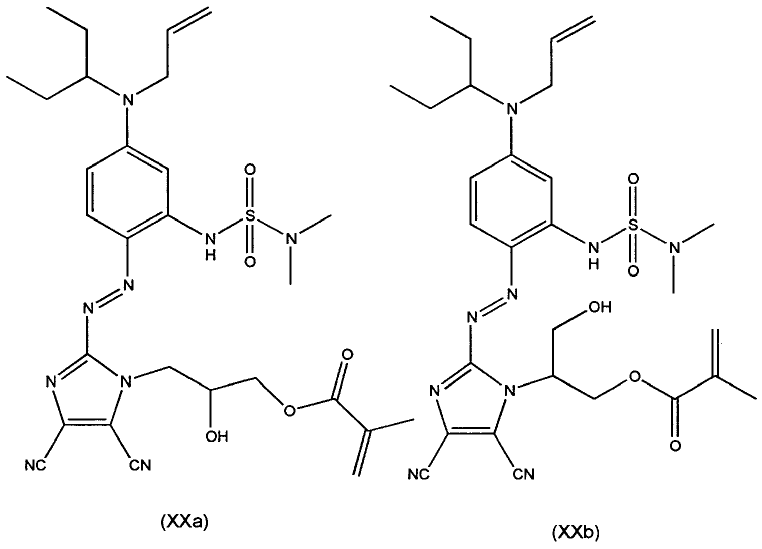 | 504 / 19 |
| 8 | 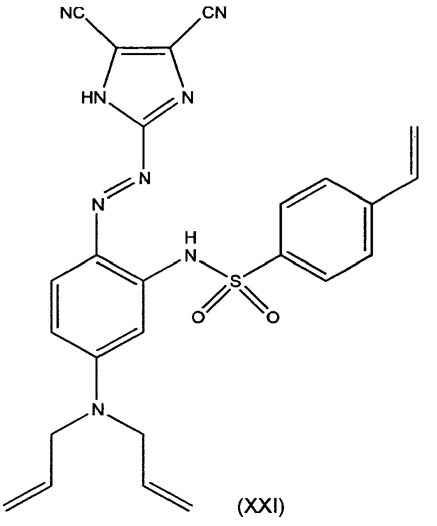 | 501 / 59 |
| 9 | 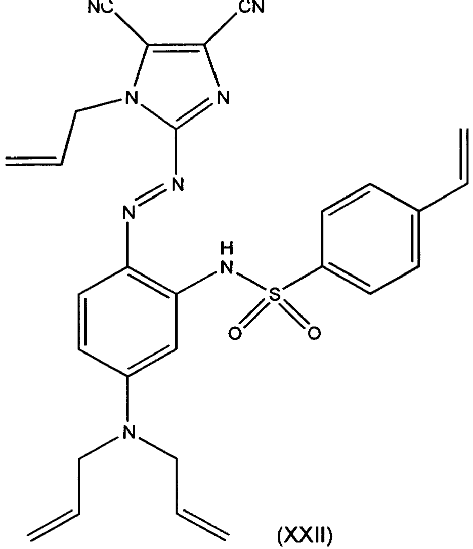 | 509 / 42 |
| 10 | 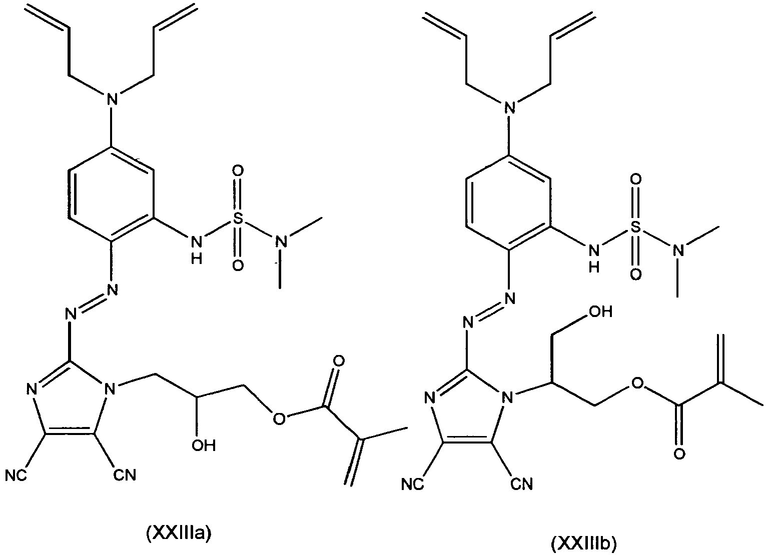 | 501 / 46 |

### Examples : Metal complexes

Metal complexes were obtained by the method described in examples 2c and 3c.

**Table 2:**

| Example | Dye ligandof example | Metal | Solubility [wt.% (solvent)] | UV-VIS (PGMEA, 0.001%): λₘₐₓ (nm) / ε (m²/g) |
|---|---|---|---|---|
| 11 | 3b | Ni | 0.1 (PGMEA) | 541 / 60 |
| 12 | 3b | Zn | 0.1 (PGMEA) | 547 / 59 |
| 13 | 4b | Zn | 1.0 (PGMEA) | 538 / 46 |
| 14 | 4c | Sn | 1.0 (PGMEA) | 544 / 36 |
| 15 | 4c | Ni | 1.0 (PGMEA) | 571 /44 |
| 16 | 5b | Ni | 0.5 (PGMEA) | 547 / 52 |
| 17 | 6b | Zn | 0.5 (PGMEA) | 531 / 54 |
| 18 | 6b | Ni | 0.5 (PGMEA) | 528 / 66 |
| 19 | 7 | Zn | 0.1 (PGMEA) | 517 / 19 |
| 20 | 8 | Ni | 0.1 (PGMEA) | 501 / 38 |
| 21 | 9 | Ni | 2.5 (PGMEA) | 531 / 46 |
| 22 | 10 | Ni | 1.0 (PGMEA) | 532/ 39 |
| 23 | 10 | Zn | 0.1 (PGMEA) | 544 / 32 |

### Comparative example 1(according to EP 0844243, example 5):

2.00 g of 2-amino-4,5-dicyanoimidazole was dissolved in 60 ml of water and 10 ml of 35% hydrochloric acid, and then 4.5 ml of an aqueous solution containing 1.14 g sodium sulfite, was drop wise added thereto at a temperature of about 1 to 5 °C for diazotization. The obtained diazotized solution was drop wise added at a temperature of about 0 to 5 °C to a solution having 5.33 g of 3-N,N-dethylamino trifluoromethane sulfonanilide*trifluoromethane sulfonate, 0.6 g of urea and 0.6 g of sodium acetate dissolved in 65 ml of methanol, and the mixture was stirred for 3 hours and then left to stand overnight. Precipitated crystals were collected by filtration and dried to obtain the compound of formula (XXIV).

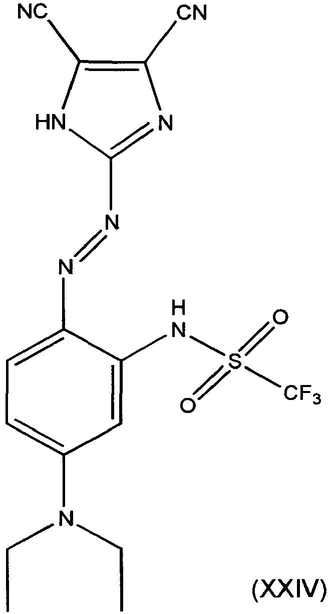

### Comparative example 2 (according to EP 0844243, example 6):

6.6 g of the compound of formula (XXIV) was dissolved in 150 ml of methanol. While stirring the mixture at 20 °C, 2.0 g of dimethyl sulfate was added drop wise thereto in two minutes, whereby the reaction temperature rose to 24 °C due to heat generation. Stirring was carried out at a temperature of about 24 to 25 °C for one hour, and then 2.2 g of potassium carbonate was added thereto, followed by stirring for 5 hours at a temperature of about 24 to 25 °C. The formed crystals were collected by filtration and dried to obtain the compound of formula (XXV).

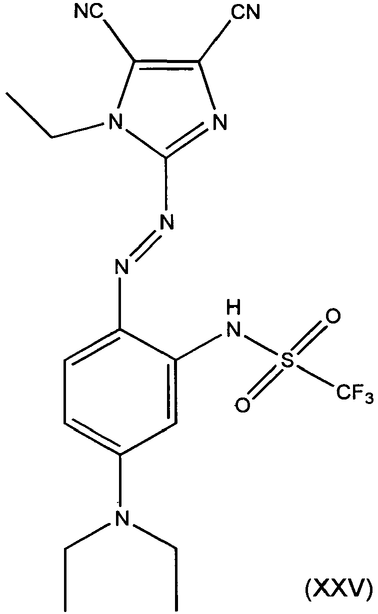

### Application example

A curable dye composition according to the invention was prepared including the following components.
- the dye according to the invention;
- a methacrylic acid/benzylmethacrylate copolymer having a weight average molecular weight of 28,000, which is mixed in a weight ratio of 30:70;
- photoinitiator CGI-124 available from BASF SE (Irgacure OXE 01; CAS-No.: [253585-83-0], 1-[4-(phenylthio)phenyl]-1,2-octanedione2-(O-benzoyloxime));
- Dipentaerythritolhexaacrylate
- Propylene glycol monomethyl ether acetate and ethyl 3-ethoxypropionate.

### Color filter

1.7 g of the photoinitiator is dissolved in 31.1 g of propylene glycol monomethyl ether acetate and 17.3 g of ethyl 3-ethoxypropionate as solvent. The solution is agitated for 2 hours at room temperature. Next, 3.9 g of the dye as prepared in example 11-23, 3.5 g of the methacrylic acid/benzylmethacrylate copolymer, and 8.5 g of dipentaerythritolhexaacrylate are added thereto. The mixture is agitated for 2 hours at room temperature (20 °C). The mixture is agitated for 1 hour at room temperature. The solution is filtrated three times to remove impurities, yielding the curable dye composition according to the invention.

### Comparative Example 3

A curable dye composition is prepared according to the method described above, except 3.9 g of a dye of comparative example 1 were used instead of the dye of example 11-23.

### Comparative Example 4

A curable dye composition is prepared according to the method described above, except 3.9 g of a dye of comparative example 2 were used instead of the dye of example 11-23.

### Experimental Example

The curable dye composition according to the invention and the curable dye composition of the comparative example are coated on a 2*5 cm² glass substrate by adding one drop to a glass plate, attaching a second plate that a thin film is formed and tearing the plated apart in a way that a thin film is formed. The resulting plate is then pre-baked at 90 °C for 3 minutes. The resulting product is cooled under air and then radiated by UV having a wavelength of 365 nm to an exposure amount of 100 mJ/cm², fabricating a thin film.

This film is further post-baked at 230 °C in a hot air drier for 30 minutes, preparing a cured thin film. All films from dyes accordint to the invention (examples 11-23) and both films of dyes of comparative examples 1 and 2 show brilliant colors.

The durability of these films is evaluated by dipping the cured thin films (1) in a N-methylpyrrolidone (NMP) solvent at room temperature for 30 minutes, and (2) in a mixed solvent of N-methylpyrrolidone (NMP) and ethylethoxypropionate (hereinafter referred to as "EEP") mixed in a volume ratio of 1:1 at 80 °C for 10 minutes.

The durability was recorded by comparison of the extinction at λₘₐₓ of the film before and after dipping.

Results are given in Table 3.

| Example | λₘₐₓ (nm) | Extinction of film before dipping | Extinction after Dipping in NMP, method (1) | Extinction after Dipping in NMP/EEP, method (2) |
|---|---|---|---|---|
| | | | (% of extinction before dipping) | (% of extinction before dipping) |
| 11 | 541 | 1,02 | 0.99 (99) | 1.01 (99) |
| 12 | 547 | 2,43 | 2,35 (97) | 2,38 (98) |
| 13 | 538 | 1.36 | 1.30 (96) | 1.27 (93) |
| 14 | 544 | 0.96 | 0.95 (99) | 0.91 (95) |
| 15 | 571 | 1.36 | 1.35 (99) | 1.29 (95) |
| 16 | 547 | 1.69 | 1.67 (99) | 1.66 (98) |
| 17 | 531 | 0.91 | 0.85 (93) | 0.90 (98) |
| 18 | 528 | 1.24 | 1.19 (96) | 1.18 (95) |
| 19 | 517 | 1.76 | 1.68(95) | 1.64(93) |
| 20 | 501 | 1.23 | 1.18 (96) | 1.15 (93) |
| 21 | 531 | 1.46 | 1.45 (99) | 1.41 (97) |
| 22 | 532 | 1.09 | 1.02 (94) | 0.99 (91) |
| 23 | 544 | 1.68 | 1.58 (94) | 1.65 (98) |
| Comp. 1 | 511 | 2.18 | 1,23 (56) | 1,36 (62) |
| Comp 2 | 533 | 2.36 | 1,68 (71) | 1,45 (61) |

The dyes according to the invention have significantly improved durability compared to the dyes of comparative examples 1 and 2.

## Claims

1. Display containing
- a W-OLED light source and
- a color filter comprising a dye, wherein the dye is comprised of a metal complex comprising a metal ion M and a deprotonated form of compound of formula (I): 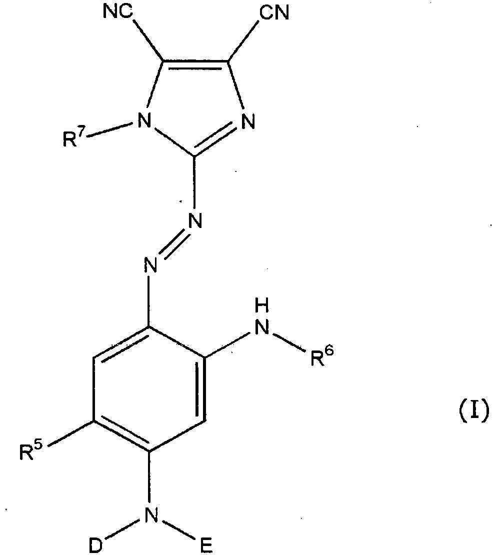 wherein
D is 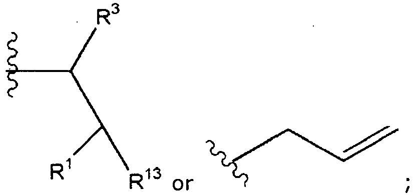
E is 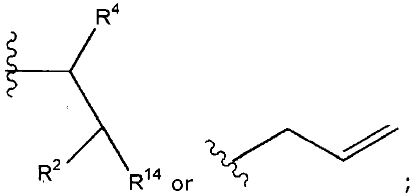
R¹ and R² are independently from each other selected from the group consisting of H, -OH, -CH₂OH, -OC₁-C₈-alkyl, -C₁-C₆-alkyl, phenyl, -C(O)OC₁-C₈-alkyl, -O-benzyl, -O-allyl, -CN, -OC(O)-C₁-C₆-alkyl, -OC(O)CF₃, -OR⁸ and -R^{x}-OR⁸;
R³ and R⁴ are, independently from each other, selected from the group consisting of H, methyl, -CH₂OH -C₁₋₆-alkyl, phenyl, -C(O)OC₁-C₈-alkyl, -OR⁸ and -R^{x}-OR⁸.
R⁵ is selected from the group consisting of -H, -C₁-C₈-alkyl, -OC₁-C₈-alkyl, -C(O)OC₁-C₈ alkyl, -R^{x}-OR⁸, -OC_{y}H_{2y}-R⁸ and -Cl;
R⁶ is selected from the group consisting of -C(O)CF₃, -S(O)₂C₁-C₁₂-alkyl, -S(O)₂CF₃, -S(O)₂N(C₁-C₈-alkyl)₂, -S(O)₂NR¹⁰R¹¹ and -S(O)₂-phenylen-C(R⁹)=CH₂.
R⁷ is selected from the group consisting of H, methyl, ethyl, branched or unbranched -C₃-C₆-alkyl, -C₃-C₆-alkenyl, -C₃-C₆-alkynyl -C₃-C₆-cycloalkyl, benzyl or substituted benzyl, -C_{y}H_{2y}-R⁸, -OC_{y}H_{2y}-R⁸, -R^{x}-OR⁸, -C₂H₄-CN, -C₂H₄-C(O)OC₁-C₈-alkyl, -CH₂-CH(OH)-phenyl, -CH(phenyl)-CH₂(OH), -CH₂-CH(OR⁸)-phenyl and -CH(phenyl)-CH₂(OR⁸);
wherein R⁸ is -C(O)-C(R⁹)=CH₂ or -S(O)₂-phenylen-C(R⁹)=CH₂.
wherein R⁹ is H or methyl;
wherein R¹⁰ and R¹¹ are independently either -C₁-C₆-alkyl or -R^{x}-OR⁸;
wherein y is an integer ranging from 1 to 4;
wherein R¹³ and R¹⁴ are independently selected from the group consisting of H, phenyl and -R^{x}-OR⁸;
wherein R^{x} is a -C₂-C₈-alkanediyl which may be substituted with substituents selected from the group consisting of -OH, -OC(O)CF₃, -OC(O)C₁-C₈-alkyl, - OC(O)phenyl, -OC(O)benzyl and -OC(O)C₅-C₆cycloalkyl; and
wherein at least one of the substituents selected from R¹, R², R³, R⁴, R⁵, R⁶ and R⁷ comprises the moiety -C(O)-C(R⁹)=CH₂ or -S(O)₂-phenylen-C(R⁹)=CH₂.

2. Display according to claim 1 wherein the substituents R⁶ and/or R⁷ comprise the moiety -C(O)-C(R⁹)=CH₂ or -S(O)₂-phenylen-C(R⁹)=CH₂.

3. Display according one or both of claims 1 and 2 wherein M is a divalent ion selected from the group consisting of copper(II), nickel(II), zinc(II), iron(II), manganese (II), tin(II) and cobalt(II).

4. Display according to one or more of claims 1 to 3, wherein R⁷ is selected from the group of -C_{y}H_{2y}-R⁸, -R^{x}-OR⁸, -CH₂-CH(OR⁸)-phenyl and -CH(phenyl)-CH₂(OR₈);
wherein R⁶ is -S(O)₂-N(Me)₂;
wherein R⁸ is -C(O)-C(R⁹)=CH₂;
wherein R⁹ is H or methyl and
wherein R^{x} is a -C₂-C₈-alkanediyl which may be substituted with substituents selected from the group consisting of -OH, -OC(O)CF₃, -OC(O)C₁-C₈-alkyl, - OC(O)phenyl, -OC(O)benzyl and -OC(O)C₅-C₆cycloalkyl.

5. Display according to one or more of claims 1 to 4, wherein R⁷ is -H or methyl and R⁶ is selected from the group consisting of -C(O)CF₃, -S(O)₂N(C₁-C₈-alkyl)₂ and -S(O)₂NR¹⁰R¹¹;
wherein R¹⁰ and R¹¹ are independently from each other -C₁-C₆-alkyl or -R^{x}-OR⁸ with the proviso that at least one of R¹⁰ and R¹¹ is -R^{x}-OR⁸;
wherein R^{x} is a -C₂-C₈-alkanediyl which may be substituted with substituents selected from the group consisting of -OH, -OC(O)CF₃, -OC(O)C₁-C₈-alkyl, - OC(O)phenyl, -OC(O)benzyl and -OC(O)C₅-C₆cycloalkyl;
wherein R⁸ is -C(O)-C(R⁹)=CH₂ and
wherein R⁹ is H or methyl.

6. Display according to one or more of claims 1 to 5, wherein the dye is represented by formula (II): 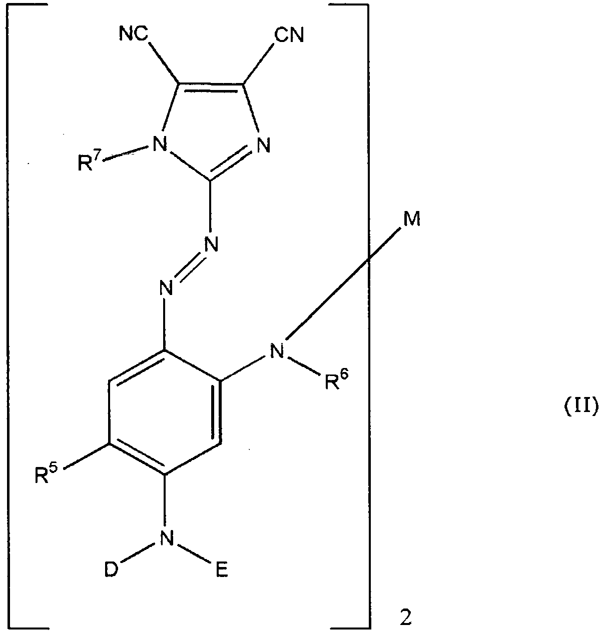 wherein
D is 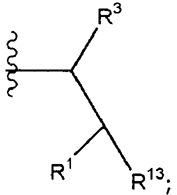
E is 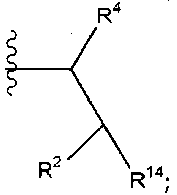
R¹, R², R³ and R⁴ are independently from each other H or methyl;
R⁵ is -H or -OCH₃;
R⁶ is either -C(O)CF₃ or -S(O)₂N(C₁-C₈-alkyl)₂;
R⁷ is 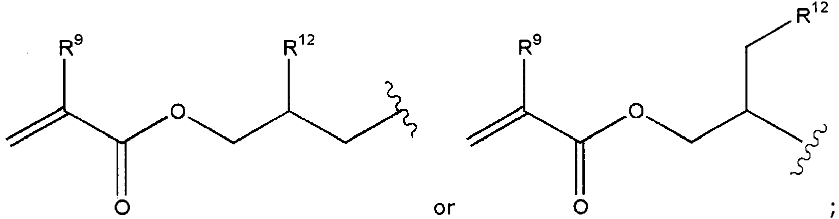
R⁹ is H or methyl;
R¹² is selected from the group consisting of -OH, -OC(O)phenyl, -OC(O)C₁-C₈-alkyl and -OC(O)CF₃;
R¹³ and R¹⁴ are both H; and
M is Ni or Zn.

7. Display according to one or more of claims 1 to 6, wherein the dye is represented by formula (III): 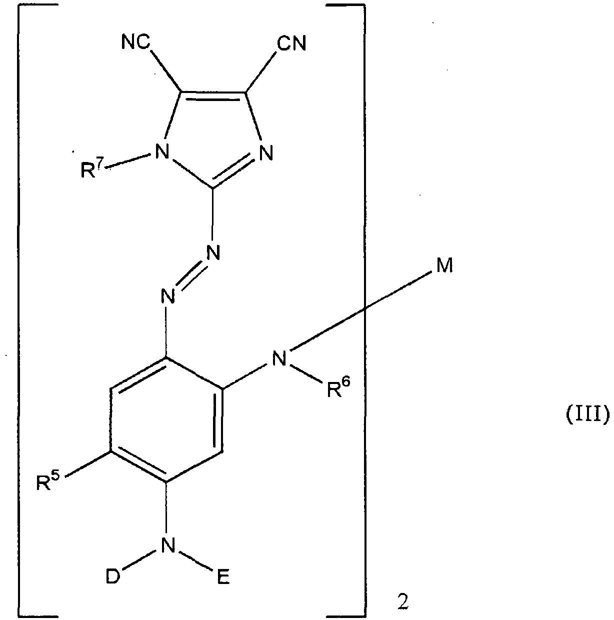 wherein
D is 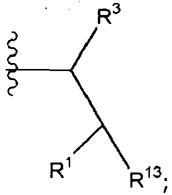
E is 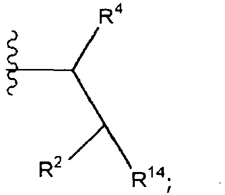
R¹ is -OH or -OR⁸;
R² is -OH or -OR⁸, with the proviso that if R¹ is -OH then R² is -OR⁸ and if R¹ is - OR⁸ then R² is -OH;
R³ and R⁴ are both H;
R⁵ is either -H or -OCH₃;
R⁶ is either -C(O)CF₃ or -S(O)₂N(C₁-C₈-alkyl)₂;
R⁷ is H;
R¹³ and R¹⁴ are independently from each other selected from the group consisting of H, phenyl and -CH₂-OR⁸;
R⁸ is -C(O)-C(R⁹)=CH₂ with R⁹ being either H or methyl; and
M is Ni or Zn.

## Patentansprüche

1. Anzeige, enthaltend
- eine W-OLED-Lichtquelle und
- einen Farbfilter, der einen Farbstoff umfasst, wobei der Farbstoff aus einem Metallkomplex besteht, der ein Metallion M und eine deprotonierte Form der Verbindung der Formel (I) umfasst: 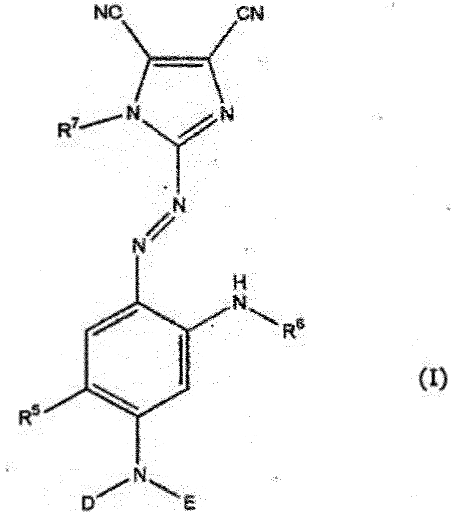 wobei 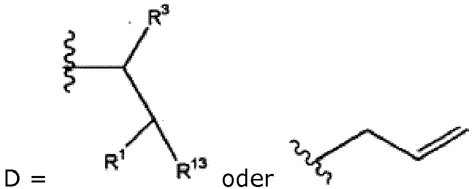
ist; 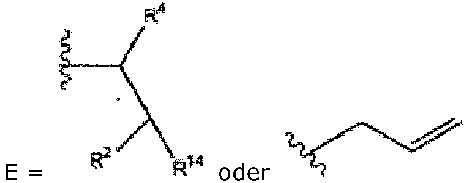
ist;
R¹ und R² unabhängig voneinander aus der Gruppe ausgewählt sind, die aus H, -OH, -CH₂OH, -O-C₁-C₈-Alkyl, -C₁-C₆-Alkyl, Phenyl, -C(O)O-C₁-C₈-Alkyl, -O-Benzyl, -O-Allyl, -CN, -OC(O)-C₁-C₆-Alkyl, -OC(O)CF₃, -OR⁸ und -R^{x}-OR⁸ besteht;
R³ und R⁴ unabhängig voneinander aus der Gruppe ausgewählt sind, die aus H, Methyl, -CH₂OH, -C₁-C₆-Alkyl, Phenyl, -C(O)O-C₁-C₈-Alkyl, -OR⁸ und -R^{x}-OR⁸ besteht;
R⁵ aus der Gruppe ausgewählt ist, die aus -H, -C₁-C₈-Alkyl, -O-C₁-C₈-Alkyl, -C(O)O-C₁-C₈-Alkyl, -R^{x}-OR⁸, -OC_{y}H_{2y}-R⁸ und -Cl besteht;
R⁶ aus der Gruppe ausgewählt ist, die aus -C(O)CF₃, -S(O)₂-C₁-C₁₂-Alkyl, -S(O)₂CF₃, -S(O)₂N(C₁-C₈-Alkyl)₂, -S(O)₂NR¹⁰R¹¹ und -S(O)₂-Phenylen-C(R⁹)=CH₂ besteht;
R⁷ aus der Gruppe ausgewählt ist, die aus H, Methyl, Ethyl, verzweigtem oder unverzweigtem -C₃-C₆-Alkyl, -C₃-C₆-Alkenyl, -C₃-C₆-Alkinyl, -C₃-C₆-Cycloalkyl, Benzyl oder substituiertem Benzyl, -C_{y}H_{2y}-R⁸, -OC_{y}H_{2y}-R⁸, -R^{x}-OR⁸, -C₂H₄-CN, -C₂H₄-C(O)O-C₁-C₈-Alkyl, -CH₂-CH(OH)-Phenyl, -CH(phenyl)-CH₂(OH), -CH₂-CH(OR₈)-Phenyl und -CH(phenyl)-CH₂(OR⁸) besteht;
wobei R⁸ = -C(O)-C(R⁹)=CH₂ oder -S(O)₂-Phenylen-C(R⁹)=CH₂ ist;
wobei R⁹ = H oder Methyl ist;
wobei R¹⁰ und R¹¹ unabhängig entweder-C₁-C₆-Alkyl oder -R^{x}-OR⁸ sind;
wobei y eine ganze Zahl im Bereich von 1 bis 4 ist;
wobei R¹³ und R¹⁴ unabhängig aus der Gruppe ausgewählt sind, die aus H, Phenyl und -R^{x}-OR⁸ besteht;
wobei R^{x} ein -C₂-C₈-Alkandiyl ist, das mit Substituenten substituiert sein kann, die aus der Gruppe ausgewählt sind, die aus -OH, -OC(O)CF₃, -OC(O)-C₁-C₈-Alkyl, -OC(O)Phenyl, -OC(O)Benzyl und -OC(O)-C₅-C₆-Cycloalkyl besteht; und
wobei wenigstens einer der Substituenten aus R¹, R², R³, R⁴, R⁵, R⁶ und R⁷ die Struktureinheit -C(O)-C(R⁹)=CH₂ oder -S(O)₂-Phenylen-C(R⁹)=CH₂ umfasst.

2. Anzeige gemäß Anspruch 1, wobei die Substituenten R⁶ und/oder R⁷ die Struktureinheit -C(O)-C(R⁹)=CH₂ oder -S(O)₂-Phenylen-C(R⁹)=CH₂ umfassen.

3. Anzeige gemäß Anspruch 1 und/oder 2, wobei M ein zweiwertiges Ion ist, das aus der Gruppe ausgewählt ist, die aus Kupfer(II), Nickel(II), Zink(II), Eisen(II), Mangan(II), Zinn(II) und Cobalt(II) besteht.

4. Anzeige gemäß einem oder mehreren der Ansprüche 1 bis 3, wobei R⁷ aus der Gruppe -C_{y}H_{2y}-R⁸, -R^{x}-OR⁸, -CH₂-CH(OR₈)-Phenyl und -CH(phenyl)-CH₂(OR⁸) ausgewählt ist;
wobei R⁶ = -S(O)₂-N(Me)₂ ist;
wobei R⁸ = -C(O)-C(R⁹)=CH₂ ist;
wobei R⁹ = H oder Methyl ist; und
wobei R^{x} ein -C₂-C₈-Alkandiyl ist, das mit Substituenten substituiert sein kann, die aus der Gruppe ausgewählt sind, die aus -OH, -OC(O)CF₃, -OC(O)-C₁-C₈-Alkyl, -OC(O)Phenyl, -OC(O)Benzyl und -OC(O)-C₅-C₆-Cycloalkyl besteht.

5. Anzeige gemäß einem oder mehreren der Ansprüche 1 bis 4, wobei R⁷ = -H oder Methyl ist und R⁶ aus der Gruppe ausgewählt ist, die aus -C(O)CF₃, -S(O)₂N(C₁-C₈-alkyl)₂ und -S(O)₂NR¹⁰R¹¹ besteht;
wobei R¹⁰ und R¹¹ unabhängig voneinander -C₁-C₆-Alkyl oder -R^{x}-OR⁸ sind, mit der Maßgabe, dass wenigstens eines von R¹⁰ und R¹¹ = -R^{x}-OR⁸ ist;
wobei R^{x} ein -C₂-C₈-Alkandiyl ist, das mit Substituenten substituiert sein kann, die aus der Gruppe ausgewählt sind, die aus -OH, -OC(O)CF₃, -OC(O)-C₁-C₈-Alkyl, -OC(O)Phenyl, -OC(O)Benzyl und -OC(O)-C₅-C₆-Cycloalkyl besteht;
wobei R⁸ = -C(O)-C(R⁹)=CH₂ ist; und
wobei R⁹ = H oder Methyl ist.

6. Anzeige gemäß einem oder mehreren der Ansprüche 1 bis 5, wobei der Farbstoff durch Formel (II) dargestellt wird: 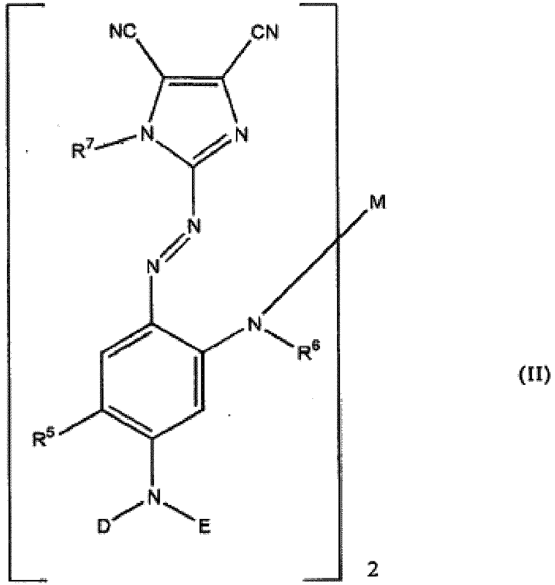 wobei 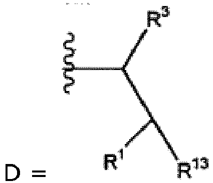
ist; 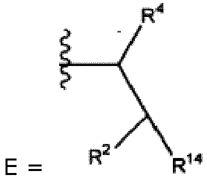
ist;
R¹, R², R³ und R⁴ unabhängig voneinander H oder Methyl sind;
R⁵ = -H oder -OCH₃ ist;
R⁶ entweder -C(O)CF₃ oder -S(O)₂N(C₁-C₈-alkyl)₂ ist; 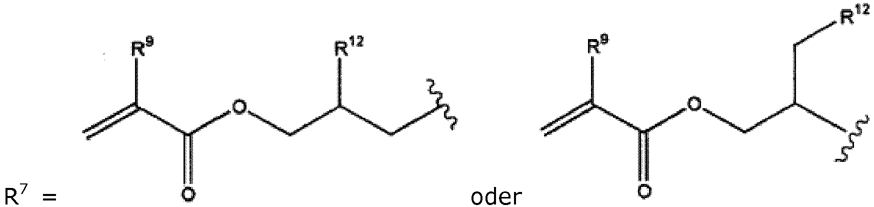 ist;
R⁹ = H oder Methyl ist;
R¹² aus der Gruppe ausgewählt ist, die aus -OH, -OC(O)Phenyl, -OC(O)-C₁-C₈-Alkyl und -OC(O)CF₃ besteht;
R¹³ und R¹⁴ beide H sind; und
M = Ni oder Zn ist.

7. Anzeige gemäß einem oder mehreren der Ansprüche 1 bis 6, wobei der Farbstoff durch Formel (III) dargestellt wird: 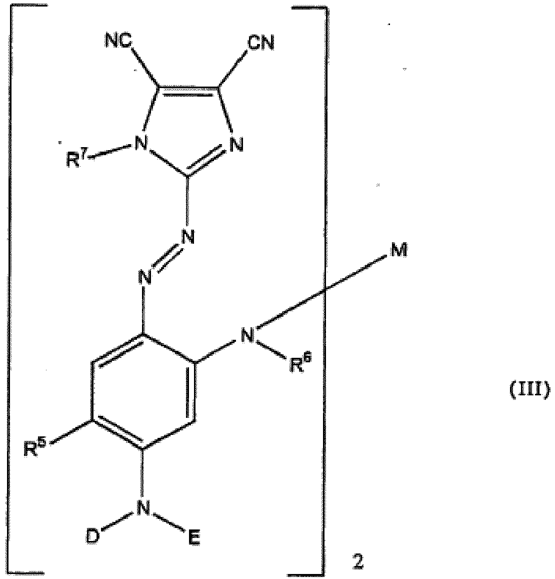 wobei 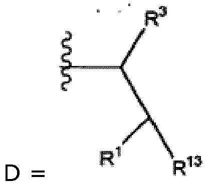
ist; 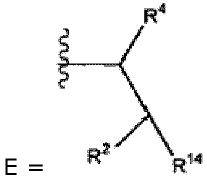 ist;
R¹ = -OH oder -OR⁸ ist;
R² = -OH oder -OR⁸ ist, mit der Maßgabe, dass dann, wenn R¹ = -OH ist, R² = -OR⁸ ist und dann, wenn R¹ = -OR⁸ ist, R² = -OH ist;
R³ und R⁴ beide H sind;
R⁵ entweder -H oder -OCH₃ ist;
R⁶ entweder -C(O)CF₃ oder -S(O)₂N(C₁-C₈-alkyl)₂ ist;
R⁷ = H ist;
R¹³ und R¹⁴ unabhängig voneinander aus der Gruppe ausgewählt sind, die aus H, Phenyl und -CH₂-OR⁸ besteht;
R⁸ = -C(O)-C(R⁹)=CH₂ ist, wobei R⁹ entweder H oder Methyl ist; und
M = Ni oder Zn ist.

## Revendications

1. Affichage, contenant
- une source de lumière W-OLED, et
- un filtre de couleur comprenant un colorant, dans lequel le colorant consiste en un complexe métallique comprenant un ion métallique M et une forme déprotonée d'un composé répondant à la formule (I) : 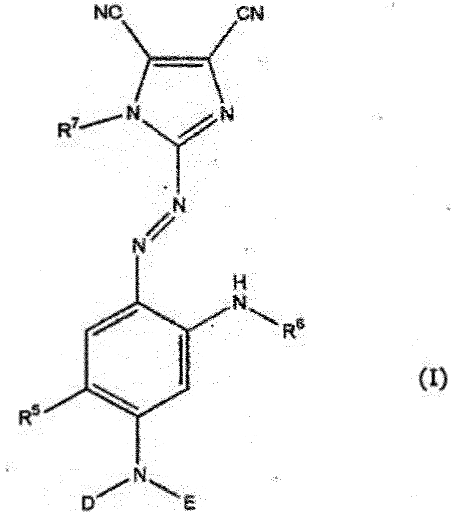 où
D est 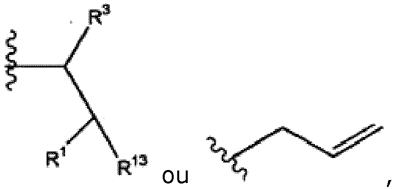
E est 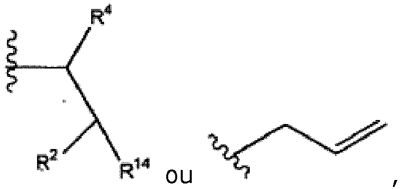
R¹ et R² sont indépendamment l'un de l'autre choisis dans le groupe consistant en H, -OH, -CH₂OH -O-C₁-C₈-alkyle, -C₁-C₆-alkyle, phényle, -C(O)O-C₁-C₈-alkyle, -O-benzyle, -O-allyle, -CN, -OC(O)-C₁-C₆-alkyle, -OC(O)CF₃, -OR⁸ et -R^{x}-OR⁸,
R³ et R⁴ sont indépendamment l'un de l'autre choisis dans le groupe consistant en H, méthyle, -CH₂OH -C₁-C₆-alkyle, phényle, -C(O)O-C₁-C₈-alkyle, -OR⁸ et -R^{x}-OR⁸,
R⁵ est choisi dans le groupe consistant en -H, -C₁-C₈-alkyle, -O-C₁-C₈-alkyle, -C(O)O-C₁-C₈-alkyle, -R^{x}-OR⁸, -OC_{y}H_{2y}-R⁸ et -Cl,
R⁶ est choisi dans le groupe consistant en -C(O)CF₃, -S(O)₂-C₁-C₁₂-alkyle, -S(O)₂CF₃, -S(O)₂N(C₁-C₈-alkyle)₂, -S(O)₂NR¹⁰R¹¹ et -S(O)₂-phénylène-C(R⁹)=CH₂,
R⁷ est choisi dans le groupe consistant en H, méthyle, éthyle; -C₃-C₆-alkyle, -C₃-C₆-alcényle, -C₃-C₆-alcynyle, ramifiés ou non ; -C₃-C₆-cycloalkyle, benzyle ou benzyle substitué, -C_{y}H_{2y}-R⁸, -OC_{y}H_{2y}-R⁸, -R^{x}-OR⁸, -C₂H₄-CN, -C₂H₄-C(O)O-C₁-C₈-alkyle, -CH₂-CH(OH)-phényle, -CH(phényle)-CH₂(OH), -CH₂-CH(OR₈)-phényle et -CH(phényle)-CH₂(OR⁸),
où R⁸ est -C(O)-C(R⁹)=CH₂ ou -S(O)₂-phénylène-C(R⁹)=CH₂,
où R⁹ est H ou méthyle,
où R¹⁰ et R¹¹ sont indépendamment soit -C₁-C₆-alkyle soit -R^{x}-OR⁸,
où y est un nombre entier compris entre 1 et 4,
où R¹³ et R¹⁴ sont indépendamment choisis dans le groupe consistant en H, phényle et -R^{x}-OR⁸,
où R^{x} est un -C₂-C₈-alkandiyle qui peut être substitué avec des substituants choisis dans le groupe consistant en -OH, -OC(O)CF₃, -OC(O)-C₁-C₈-alkyle, -OC(O)phényle, -OC(O)benzyle et -OC(O)-C₅-C₆-cycloalkyle, et
dans lequel au moins l'un des substituants choisis parmi R¹, R², R³, R⁴, R⁵, R⁶ et R⁷ comprend le groupement -C(O)-C(R⁹)=CH₂ ou -S(O)₂-phénylène-C(R⁹)=CH₂.

2. Affichage selon la revendication 1, dans lequel les substituants R⁶ et/ou R⁷ comprennent le groupement -C(O)-C(R⁹)=CH₂ ou -S(O)₂-phénylène-C(R⁹)=CH₂.

3. Affichage selon la revendication 1 et/ou 2, dans lequel M est un ion divalent choisi dans le groupe consistant en cuivre(II), nickel(II), zinc(II), fer(II), manganèse(II), étain(II) et cobalt(II).

4. Affichage selon l'une ou plusieurs des revendications 1 à 3, dans lequel R⁷ est choisi dans le groupe -CyH_{2y}-R⁸, -R^{x}-OR⁸, -CH₂-CH(OR₈)-phényle et -CH(phényle)-CH₂(OR⁸),
où R⁶ est -S(O)₂-N(Me)₂,
où R⁸ est -C(O)-C(R⁹)=CH₂,
où R⁹ est H ou méthyle, et
où R^{x} est un -C₂-C₈-alkandiyle qui peut être substitué avec des substituants choisis dans le groupe consistant en -OH, -OC(O)CF₃, -OC(O)-C₁-C₈-alkyle, -OC(O)phényle, -OC(O)benzyle et -OC(O)-C₅-C₆-cycloalkyle.

5. Affichage selon l'une ou plusieurs des revendications 1 à 4, dans lequel R⁷ est -H ou méthyle, et R⁶ est choisi dans le groupe consistant en -C(O)CF₃, -S(O)₂N(C₁-C₈-alkyle)₂ et -S(O)₂NR¹⁰R¹¹,
où R¹⁰ et R¹¹ sont indépendamment l'un de l'autre -C₁-C₆-alkyle ou -R^{x}-OR⁸, à la condition qu'au moins un parmi R¹⁰ et R¹¹ est -R^{x}-OR⁸,
où R^{x} est un -C₂-C₈-alkandiyle qui peut être substitué avec des substituants choisis dans le groupe consistant en -OH, -OC(O)CF₃, -OC(O)-C₁-C₈-alkyle, -OC(O)phényle, -OC(O)benzyle et -OC(O)-C₅-C₆-cycloalkyle
où R⁸ est -C(O)-C(R⁹)=CH₂, et
où R⁹ est H ou méthyle.

6. Affichage selon l'une ou plusieurs des revendications 1 à 5, dans lequel le colorant est représenté par la formule (II) : 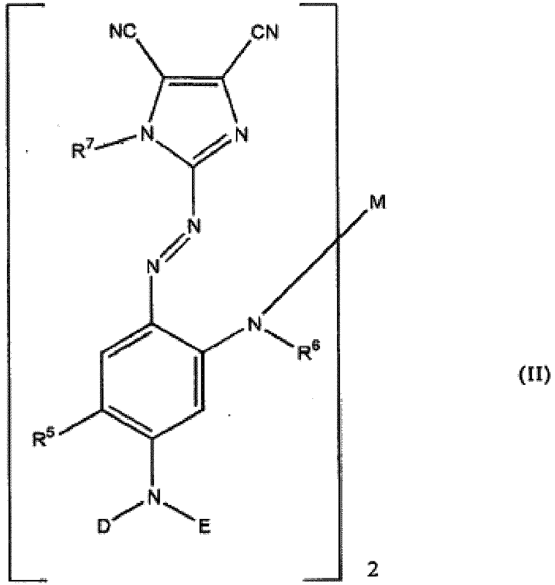 où
D est 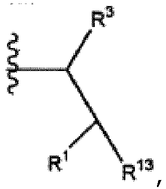
E est 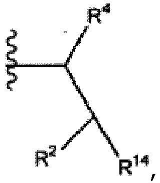 R¹, R², R³ et R⁴ sont indépendamment l'un de l'autre H ou méthyle,
R⁵ est -H ou -OCH₃,
R⁶ est soit -C(O)CF₃ soit -S(O)₂N(C₁-C₈-alkyl)₂,
R⁷ est 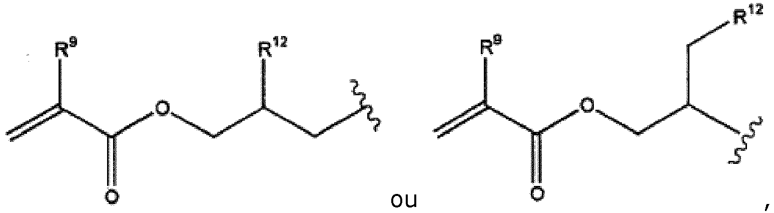 R⁹ est H ou méthyle,
R¹² est choisi dans le groupe consistant en -OH, -OC(O)phényle, -OC(O)-C₁-C₈-alkyle et -OC(O)CF₃,
R¹³ et R¹⁴ tous deux H, et
M est Ni ou Zn.

7. Affichage selon l'une ou plusieurs des revendications 1 à 6, dans lequel le colorant est représenté par la formule (III) : 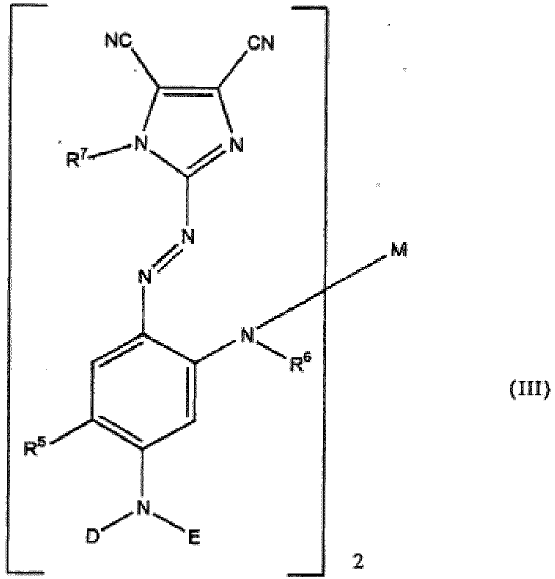 où
D est 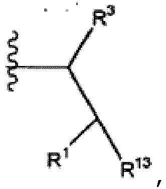
E est 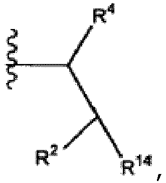 R¹ est -OH ou -OR⁸,
R² est -OH ou -OR⁸, à condition que lorsque R¹ est -OH, alors R² est -OR⁸, et lorsque R¹ est -OR⁸, alors R² est -OH,
R³ et R⁴ sont tous deux H,
R⁵ est soit -H soit -OCH₃,
R⁶ est soit -C(O)CF₃ soit -S(O)₂N(C₁-C₈-alkyl)₂,
R⁷ est H,
R¹³ et R¹⁴ sont indépendamment l'un de l'autre choisis dans le groupe consistant en H, phényle et -CH₂-OR⁸,
R⁸ est -C(O)-C(R⁹)=CH₂, où R⁹ est soit H soit méthyle, et
M est Ni ou Zn.
